# EUROPEAN PATENT APPLICATION

(11) **EP 4 753 394 A1**
(43) Date of publication of application: **03.06.2026**
(21) Application number: 25219929.4
(22) Date of filing: 02.12.2025
(51) Int. Cl.: H10B 43/10, H10B 43/27, H10B 43/50

(54) **MEMORY DEVICE AND METHOD OF MANUFACTURING MEMORY DEVICE**

(30) Priority: 02.12.2024 KR 20240176522
(71) Applicant: SK hynix Inc., Bubal-eub Icheon-si Gyeonggi-do 17336 (KR)
(72) Inventor: HAN, Yun Cheol, 17336 Icheon-si, Gyeonggi-do (KR); YEOM, Hye In, 17336 Icheon-si, Gyeonggi-do (KR); NAM, Sang Hyuk, 17336 Icheon-si, Gyeonggi-do (KR); JUNG, Yun Oh, 17336 Icheon-si, Gyeonggi-do (KR)
(74) Representative: Isarpatent

(57) **Abstract**

A memory device includes a contact, and a plurality of support structures disposed around the contact, wherein each of the support structures is formed utilizing a plurality of overlapping holes. The support structures include an insulating layer disposed within the overlapping holes. The support structures are formed by expanding and overlapping a plurality of first openings.

## Description

### BACKGROUND

### 1. Technical Field

The present disclosure generally relates to a memory device and a method of manufacturing the memory device.

### 2. Related Art

Memory devices include non-volatile memory devices that retain stored data even in the absence of a power supply. The non-volatile memory devices are classified as two-dimensional structures or three-dimensional structures, depending on the arrangement of memory cells of the non-volatile memory devices. Memory cells of a non-volatile memory device having a two-dimensional structure are arranged in a single layer on a substrate. Memory cells of a non-volatile memory device having a three-dimensional structure are stacked in a vertical direction to the substrate. Because integration density of the non-volatile memory device having three-dimensional structures is greater than the integration density of non-volatile memory devices having two-dimensional structures, electronic devices including three-dimensional non-volatile memory devices have recently increased in popularity.

### SUMMARY

According to an embodiment, a memory device may include a contact, and a plurality of support structures disposed around the contact, wherein each of the plurality of support structures is formed in a plurality of overlapping holes.

According to an embodiment, a method of manufacturing a memory device may include forming a stack structure including a plurality of sacrificial layers and a plurality of interlayer insulating layers stacked alternately in a first direction, forming a contact opening extending from a first sacrificial layer among the plurality of sacrificial layers in the first direction, forming a plurality of first openings extending through the stack structure and around the contact opening, expanding the plurality of first openings to form a plurality of overlapping holes, and forming a support structure by disposing an insulating layer within the plurality of overlapping holes.

According to an embodiment, a memory device includes a contact and a plurality of support structures disposed around the contact. Each of the support structures may include a plurality of contiguous members. A distance between centers of consecutive contiguous members may be less than a width of one of the consecutive contiguous members.

### BRIEF DESCRIPTION OF THE DRAWINGS

FIG. 1 is a diagram illustrating a memory device according to an embodiment of the present disclosure;
FIG. 2 is a diagram illustrating memory blocks of a memory device according to an embodiment of the present disclosure;
FIG. 3A and FIG. 3B are diagrams illustrating a memory device including a support structure according to an embodiment of the present disclosure;
FIG. 4A to FIG. 4Z are diagrams illustrating views of a memory device including a support structure formed utilizing a method of manufacturing a memory device including a support structure according to an embodiment of the present disclosure;
FIG. 5A and FIG. 5B are diagrams illustrating a memory device including a support structure and a support pillar according to an embodiment of the present disclosure;
FIG. 6A to FIG. 6N are diagrams illustrating views of a memory device including a support structure and a support pillar formed utilizing a method of manufacturing a memory device including a support structure and a support pillar according to an embodiment of the present disclosure;
FIG. 7A to FIG. 7F are diagrams illustrating various support structures in accordance with embodiments of the present disclosure;
FIG. 8 is a diagram illustrating a memory card system including a memory device according to an embodiment of the present disclosure; and
FIG. 9 is a diagram illustrating a solid state drive (SSD) system including a memory device according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

Terms such as "vertical," "horizontal," "top," "bottom," "above," "below," "over," "on," "side," "upper," "lower," "higher," "high," "column," "row," "level," and other terms implying relative spatial relationship or orientation are utilized only for the purpose of ease of description or reference to a drawing and are not otherwise limiting. When one element is identified as "on" or "over" another element, the elements may directly contact each other or an intervening element may be disposed between the elements.

The cross-hatching throughout the figures illustrates corresponding or similar areas between the figures rather than indicating the materials associated with the areas.

When one element is identified as "coupled" to another element, the elements may be coupled directly or through at least one intervening element between the elements. When two elements are identified as "directly coupled," one element is directly coupled to the other element without an intervening element between the two elements.

As the integration density of non-volatile memory devices including three-dimensional structure increases, support structures that prevent vertically stacked material layers from bending are advantageous. The present disclosure describes a memory device having improved support effectiveness for support structures, a simplified process of manufacturing the support structure, and a method of manufacturing the memory device.

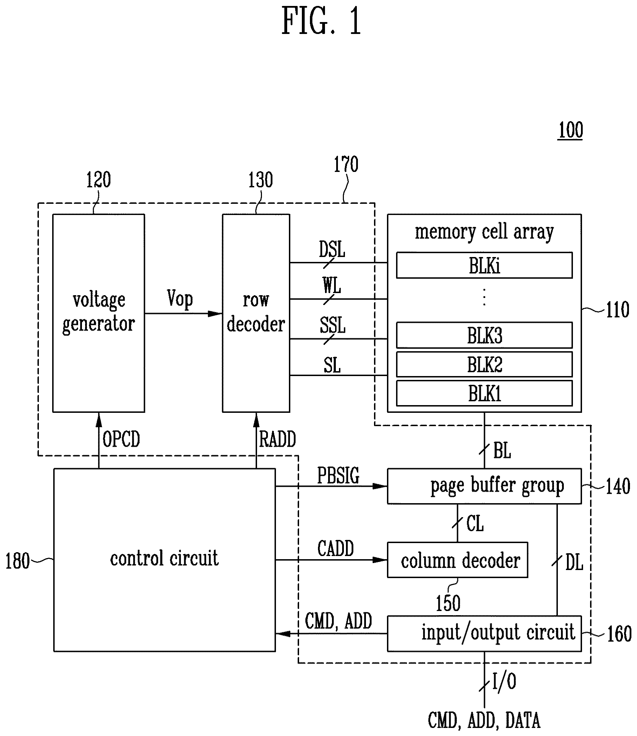

FIG. 1 is a diagram illustrating a memory device 100 according to an embodiment of the present disclosure.

Referring to FIG. 1, the memory device 100 includes a memory cell array 110, a peripheral circuit 170, and a control circuit 180.

The memory cell array 110 includes memory blocks BLK1 to BLKi, where i is a positive integer. Each of the first memory block BLK1 to the ith memory block BLKi includes memory cells capable of storing data. Drain select lines DSL, word lines WL, source select lines SSL, and a source line SL are coupled to each of the memory blocks BLK1 to BLKi, and bit lines BL are commonly coupled to the memory blocks BLK1 to BLKi.

The memory blocks BLK1 to BLKi have a three-dimensional structure. Each of memory blocks having a three-dimensional structure include memory cells stacked, for example, in a vertical direction on a substrate.

Each of the memory cells stores one-bit data, or two-bit data, three-bit data, four-bit data, five-bit data, and so forth according to a program method. For example, a method in which one-bit data is stored in one memory cell is referred to as a single-level cell (SLC) method, and a method in which two-bit data is stored in one memory cell is referred to as a multi-level cell (MLC) method. A method in which three-bit data is stored in one memory cell is referred to as a triple-level cell (TLC) method, and a method in which four-bit data is stored in one memory cell is referred to as a quad-level cell (QLC) method.

The peripheral circuit 170 is configured to perform a program operation that stores data in the memory cell array 110, a read operation that outputs data stored in the memory cell array 110, and an erase operation that erases data stored in the memory cell array 110. For example, the peripheral circuit 170 includes a voltage generator 120, a row decoder 130, a page buffer group 140, a column decoder 150, and an input/output circuit 160.

The voltage generator 120 generates various operating voltages Vop used during a program operation, a read operation, or an erase operation in response to an operation code OPCD. For example, the voltage generator 120 may be configured to generate program voltages, turn-on voltages, turn-off voltages, negative voltages, pre-charge voltages, verify voltages, read voltages, pass voltages, or erase voltages in response to the operation code OPCD. The operating voltages Vop generated by the voltage generator 120 are applied to the drain select lines DSL, the word lines WL, the source select lines SSL, and the source line SL of a selected memory block by the row decoder 130.

The program voltages are applied to a selected word line among the word lines WL during a program operation and are used to increase threshold voltages of memory cells coupled to the selected word line. The turn-on voltages are applied to the drain select lines DSL or the source select lines SSL and are used to turn on the drain select transistors and the source select transistors. The turn-off voltages are applied to the drain select lines DSL or the source select lines SSL and are used to turn off the drain select transistors and the source select transistors. For example, the turn-off voltages may be set to 0 V. The pre-charge voltages may be higher than 0 V and may be applied to the bit lines BL during a read operation. The verify voltages are used during a verify operation to determine whether threshold voltages of selected memory cells are increased to a target level. The verify voltages may be set to various levels according to the target level and may be applied to the selected word line.

The read voltages are applied to the selected word line during a read operation of the selected memory cells. For example, the read voltages may be set to various levels according to a program method of the selected memory cells. The pass voltages are applied to unselected word lines among the word lines WL during a program or read operation and are used to turn on memory cells coupled to the unselected word lines. The erase voltages are used during an erase operation to erase memory cells included in the selected memory block and are applied to the source line SL.

The row decoder 130 is configured to transfer the operating voltages Vop to the drain select lines DSL, the word lines WL, the source select lines SSL, and the source line SL that are coupled to a memory block selected according to a row address RADD. For example, the row decoder 130 is coupled to the voltage generator 120 through global lines and is coupled to the memory blocks BLK1 to BLKi through the drain select lines DSL, the word lines WL, the source select lines SSL, and the source line SL.

The page buffer group 140 includes page buffers (not shown) respectively coupled to the memory blocks BLK1 to BLKi. The page buffers are coupled to the memory blocks BLK1 to BLKi through the bit lines BL. During a read operation, the page buffers sense a current or a voltage of the bit lines BL that varies according to the threshold voltages of the selected memory cells and temporarily stores sensed data in response to page buffer control signals PBSIG.

The column decoder 150 is configured to facilitate transfer of data between the page buffer group 140 and the input/output circuit 160 in response to a column address CADD. For example, the column decoder 150 is coupled to the page buffer group 140 through column lines CL and transfers enable signals through the column lines CL. The page buffers included in the page buffer group 140 receive or output data through data lines DL in response to the enable signals.

The input/output circuit 160 is configured to receive or output a command CMD, an address ADD, or data through input/output lines I/O. For example, the input/output circuit 160 transfers the command CMD and the address ADD, which are received from an external controller through the input/output lines I/O, to the control circuit 180 and transfers data, which is received from the external controller through the input/output lines I/O, to the page buffer group 140. The input/output circuit 160 outputs data transferred from the page buffer group 140 to the external controller through the input/output lines I/O.

The control circuit 180 outputs at least one of the operation code OPCD, the row address RADD, the page buffer control signals PBSIG, and the column address CADD in response to the command CMD and the address ADD. For example, when the command CMD input to the control circuit 180 corresponds to a program operation, the control circuit 180 controls the peripheral circuit 170 to perform the program operation on a memory block selected by the address ADD. When the command CMD input to the control circuit 180 corresponds to a read operation, the control circuit 180 controls the peripheral circuit 170 to perform the read operation on the memory block selected by the address ADD and to output read data. When the command CMD input to the control circuit 180 corresponds to an erase operation, the control circuit 180 controls the peripheral circuit 170 to perform the erase operation on the selected memory block.

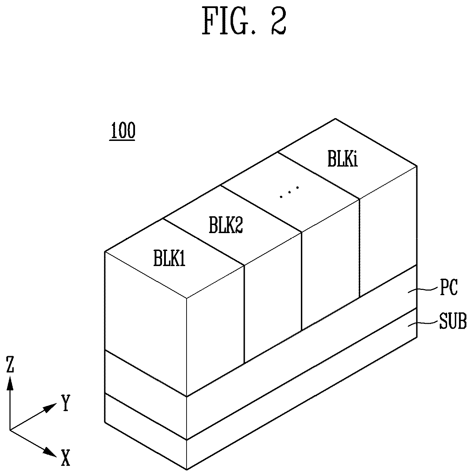

FIG. 2 is a diagram illustrating memory blocks of the memory device 100 according to an embodiment of the present disclosure.

Referring to FIG. 2, the memory device 100 includes the memory blocks BLK1 through BLKi disposed on a peripheral circuit structure PC that is disposed over a substrate SUB. The memory blocks BLK1 to BLKi at least overlap the peripheral circuit structure PC.

The substrate SUB may be a single crystal semiconductor layer. For example, the substrate SUB may be a bulk silicon substrate, a silicon-on-insulator substrate, a germanium substrate, a germanium-on-insulator substrate, a silicon-germanium substrate, or an epitaxial thin film formed through a selective epitaxial growth method.

The peripheral circuit structure PC includes, for example, the peripheral circuit 170 including the row decoder 130, the column decoder 150, the page buffer group 140, and the control circuit 180 that controls operation of the memory blocks BLK1 to BLKi. For example, the peripheral circuit structure PC may include an NMOS transistor, a PMOS transistor, a resistor, and a capacitor that are electrically coupled to the memory blocks BLK1 to BLKi. The peripheral circuit structure PC is disposed between the substrate SUB and the memory blocks BLK1 to BLKi in the example of FIG. 2.

Each of the memory blocks BLK1 to BLKi includes a source structure, bit lines, cell strings that are electrically coupled to the source structure and the bit lines, word lines that are electrically coupled to the cell strings, and select lines that are electrically coupled to the cell strings. Each of the cell strings includes memory cells and select transistors that are coupled in series by a cell plug. Each of the select lines is a gate electrode of a corresponding select transistor, and each of the word lines is a gate electrode of a corresponding memory cell.

In an embodiment, the substrate SUB, the peripheral circuit structure PC, and the memory blocks BLK1 to BLKi are stacked in a reverse order with respect to the order shown in FIG. 2. For example, the peripheral circuit structure PC is disposed over the memory blocks BLK1 to BLKi.

In an embodiment, contrary to FIG. 2, the peripheral circuit structure PC is disposed over some areas of the substrate SUB that might not overlap with the memory blocks BLK1 to BLKi. For example, the peripheral circuit structure PC and the memory blocks BLK1 to BLKi may be disposed in areas of the substrate SUB that do not overlap.

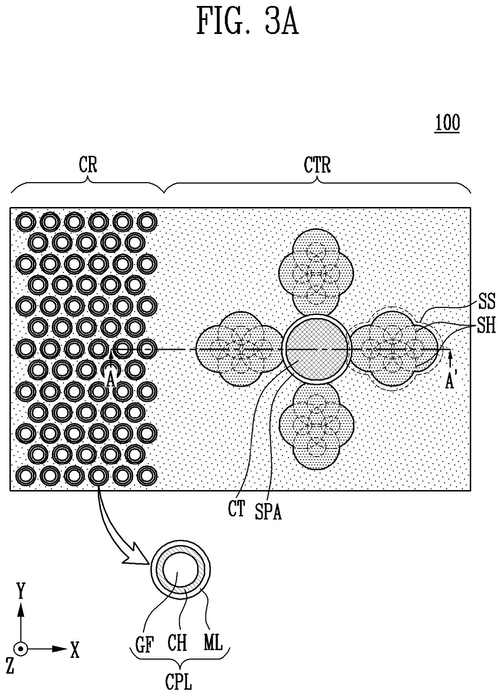

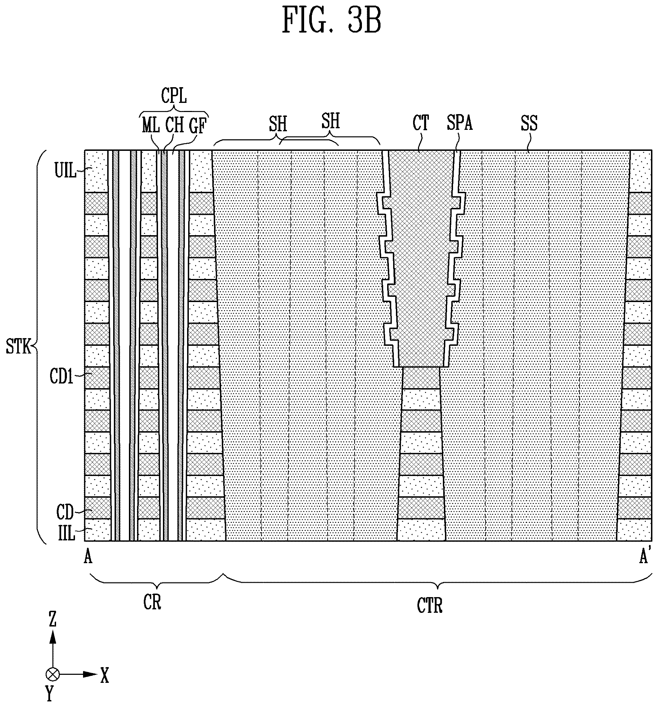

FIG. 3A and FIG. 3B are diagrams illustrating a memory device 100 including a support structure according to an embodiment of the present disclosure. FIG. 3A is a plan view illustrating a layout of the memory device 100 according to an embodiment of the present disclosure. FIG. 3B shows a cross-section taken along line A-A' of FIG. 3A.

Referring to FIG. 3A, the memory device 100 has a cell region CR and a contact region CTR. The contact region CTR and the cell region CR are distributed in the X direction. The contact region CTR extends in the X direction from the cell region CR. Unlike the contact regions CTR shown in FIG. 3A, the contact region CTR may extend from the cell region CR in a Y direction or may extend in the X direction and the Y direction. The cell region CR and the contact region CTR may be arranged in various ways.

Cell plugs CPL are located in the cell region CR. The cell plugs CPL are arranged in the X direction and the Y direction. The cell plugs CPL are spaced apart from each other in the X direction and the Y direction. Each of the cell plugs CPL extends in a Z direction. Each of the cell plugs CPL is electrically coupled to a bit line, for example, the bit line BL of FIG. 1, and a source line, for example, the source line SL of FIG. 1, through a wiring structure.

Each of the cell plugs CPL includes a memory layer ML, a channel layer CH, and a gap-fill layer GF. The memory layer ML may have a cylindrical shape. The memory layer ML surrounds the channel layer CH. Although not shown, the memory layer ML includes a blocking layer, a charge trap layer, and a tunnel insulating layer. The channel layer CH is formed along an inner wall of the memory layer ML. The gap-fill layer GF fills the channel layer CH. The gap-fill layer GF may have a cylindrical shape surrounded by the channel layer CH.

The blocking layer and the tunnel insulating layer included in the memory layer ML may include an oxide layer, such as a silicon oxide layer, or an oxynitride layer, such as a silicon oxynitride layer, or may include a combination thereof. The charge trap layer included in the memory layer ML may include a nitride layer or a variable resistance material. The channel layer CH may include an undoped silicon layer or a doped silicon layer. The gap-fill layer GF may include an insulating layer, such as an oxide layer.

A contact CT is located in the contact region CTR. A plurality of contacts are disposed in the contact area CTR, although FIG. 3A illustrates only one contact CT. The contact CT extends in the Z direction. The contact CT includes a conductive material. The contact CT may be referred to as a contact plug.

A spacer SPA surrounds side surfaces of the contact CT. The contact CT may fill the interior region of the spacer SPA. The spacer SPA includes an insulating layer. For example, the spacer SPA may include an oxide layer.

Support structures SS are located in the contact region CTR. The support structures SS are disposed around the contact CT. For example, the support structures SS may extend from the contact CT in the X direction, the Y direction, a direction opposite to the X direction, a direction opposite to Y direction, or any direction in the X-Y plane. The support structures SS are spaced apart. The support structures SS may contact the spacer SPA. The support structures SS may partially overlap the contact CT in the Z direction. The support structures SS may include an insulating material.

Each of the support structures SS has a shape formed utilizing overlapping support holes SH formed during the manufacturing process. One of the support structures SS may be formed from two or more support holes SH that overlap. For example, in FIG. 3A, each of the support structures SS is formed utilizing four overlapping support holes SH. Each of the support structures SS includes an insulating layer such as an oxide layer disposed or filled in the support holes SH that overlap.

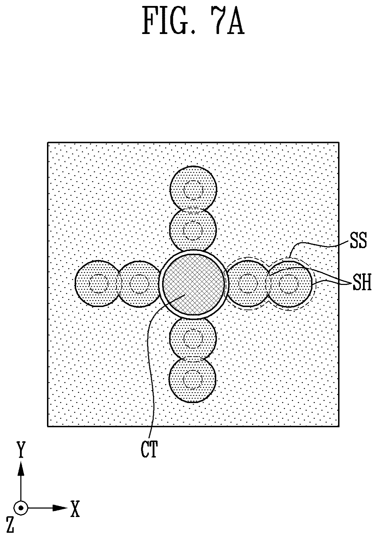

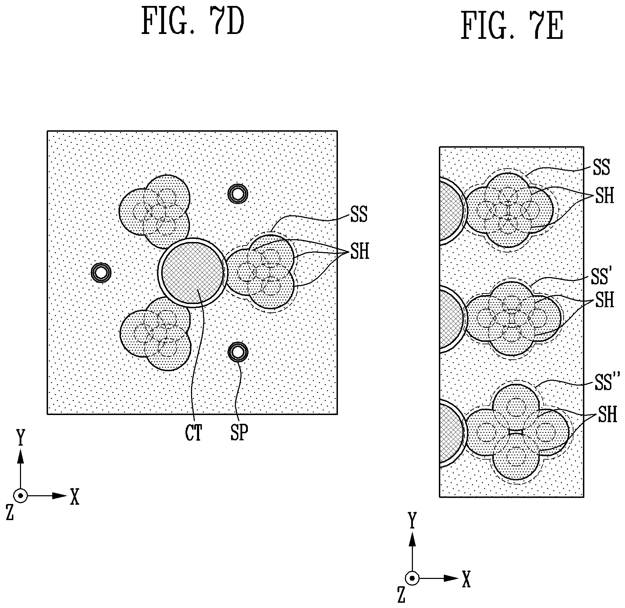

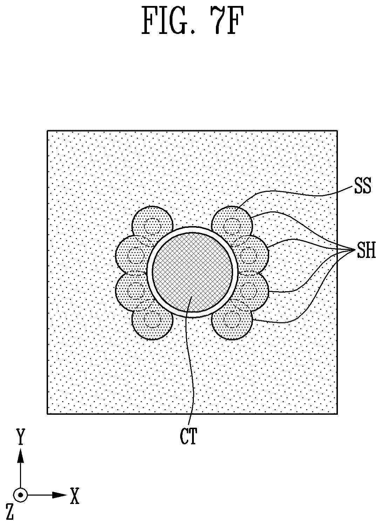

In the present disclosure, support holes SH that overlap, also referred to as overlapping holes or overlapping support holes, include holes that are contiguous, for example, because openings utilized to form the support holes are expanded from a center or middle location of each opening by removing material adjacent to the opening until the expanded openings are adjacent and form a single contiguous aperture for each support structure SS. The term "support hole" does not indicate that a support hole SH provides physical support but rather is so named because the process of forming the support structures SS utilizes the support holes SH. Alternatively, support holes SH that overlap include regions in common between adjacent or consecutive support holes SH in an XY plane. In the example of FIG. 3A, centers of all four overlapping support holes SH form vertices of a parallelogram, although the present disclosure is not limited to this example. For example, the support structure SS may be formed from two, three, five, or more support holes SH that overlap, as described, for example, with reference to FIG. 7A to FIG. 7F. For example, the support structure SS may include four support holes SH that overlap, although two support holes SH of the four support holes SH do not overlap in some embodiments, as described with reference to FIG. 7E and FIG. 7F. For example, the support structure SS may have a shape in which centers of the overlapping support holes SH are arranged in a line or arc rather than forming vertices of a shape such as a quadrilateral, parallelogram, rectangle, triangle, pentagon, hexagon, or other shape.

Referring to FIG. 3B, the memory device 100 includes a stack structure STK. The stack structure STK includes conductive layers CD and interlayer insulating layers IIL. The conductive layers CD are alternately stacked with the interlayer insulating layers IIL in the Z direction. The stack structure STK includes an upper insulating layer UIL. The conductive layers CD may include at least one of tungsten (W), cobalt (Co), nickel (Ni), molybdenum (Mo), silicon (Si), or polysilicon (poly-Si). The conductive layers CD correspond, for example, to gate lines, such as the drain selection lines DSL, the word lines WL, and the source selection lines SSL shown in FIG. 1. The interlayer insulating layers IIL may include an oxide layer, such as a silicon oxide layer. The upper insulating layer UIL may include the same material as the interlayer insulating layers IIL.

The cell plug CPL extend through the cell region CR of the stack structure STK. Each of the cell plugs CPL may include the memory layer ML, the channel layer CH, and the gap-fill layer GF. The memory cells or the select transistors are formed at intersections of the cell plug CPL and the conductive layers CD. The cell plugs CPL may be used as the channel region of a cell string.

The support structures SS extend through the contact region CTR of the stack structure STK. The support structures SS extend in the Z direction. The support structures SS include support holes SH that overlap. Because FIG. 3B corresponds to the cross-section taken along line A-A' of FIG. 3A, four support holes SH are utilized to form the support structures SS. Because the four support holes SH utilized to form each of the support structures SS overlap, a sidewall of the stack structure STK is not present between the support holes. Unlike FIG. 3B, a sidewall of the stack structure STK, may be present between two of the support holes SH included in each of the support structures SS. For example, when the distance between two of the support holes SH is large enough that the support holes SH do not overlap along the line A-A', a sidewall of the stack structure STK remains between the support holes SH, such as shown in the support structure SS'' FIG. 7E. In an embodiment, a sidewall is not present at the top of the support holes SH, although a sidewall is present at a bottom of the support holes SH. The support structures SS are formed in the overlapping support holes SH. A support structure comprises a plurality of contiguous members. For example, a contiguous member may be considered to be formed in each overlapping hole, the resulting construction forming a single support structure. The contiguous members may be formed simultaneously utilizing an insulating layer. A distance between centers or middles of consecutive contiguous members is less than a width of one of the consecutive contiguous members, thus the contiguous members may be considered to be overlapping.

The contact CT extends in the Z direction in the contact region CTR of the stack structure STK. The contact CT extends in the Z direction from a first conductive layer CD1 among the conductive layers CD included in the stack structure STK. A lower surface of the contact CT contacts an area of an upper surface of the first conductive layer CD1. The contact CT is electrically coupled to the first conductive layer CD1. The cross-section shown in FIG. 3B does not show the first conductive layer CD1 extending between the cell region CR and the contact CT in the contact region CTR, although the first conductive layer CD1 is coupled to the contact CT through an electrical path between the support structures SS as shown in FIG. 3A.

The side surface of the contact CT includes an alternating concave and convex surfaces, such as a square sawtooth. The contact CT includes protrusions extending between the contact and the conductive layers CD. The protrusions of the contact CT may be located at a level corresponding to a level of the conductive layers CD.

The spacer SPA surrounds the side surfaces of the contact CT. The spacer SPA extends along the protrusions of the contact CT. The spacer SPA may have an alternating concave and convex structure corresponding to the shape of the contact CT. The spacer SPA includes protrusions and recesses. The protrusions along the outer surface of the spacer SPA may be located at a level corresponding to the level of the conductive layers CD, and the recesses along the outer surface of the spacer SPA may be located at a level corresponding to the level of the interlayer insulating layers ILL. The spacer SPA insulates the contact CT from conductive layers CD other than the first conductive layer CD1. For example, the spacer SPA insulates and separates the contact CT from the conductive layers CD located above the first conductive layer CD1 in the stack structure STK.

The support structures SS contacts the outer surface of the spacer SPA. Referring to FIG. 3A and FIG. 3B, the support structures SS contact regions of the outer surface of the spacer SPA, and a support structures SS extends from the contact CT in the X direction, a support structures SS extends from the contact CT in the Y direction, a support structures SS extends from the contact CT in the direction opposite the X direction, and a support structures SS extends from the contact CT in the direction opposite the Y direction. For example, the support structures SS contact an outer side surface of the spacer SPA, and contact a lower surface of the spacer SPA.

The support structures SS contact the lower surface of the contact CT. The lower surface of the contact CT contacts the first conductive layer CD1 and the support structure SS. The support structures SS overlap the contact CT in the Z direction.

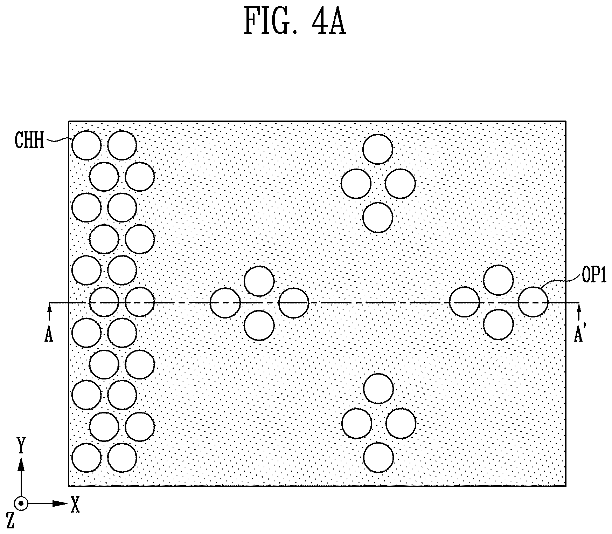

The shape of the support hole SH disposed closest to the contact CT among the support holes SH is determined by or corresponds to the shape of the contact CT and the shape of the spacer SPA. Details regarding the shapes of the support structures SS and the support holes SH are described with reference to FIG. 4A to FIG. 4Z.

FIG. 4A to FIG. 4Z are diagrams illustrating views of a memory device including a support structure formed utilizing a method of manufacturing the memory device 100 including the support structure SS according to an embodiment of the present disclosure.

FIG. 4A to FIG. 4Z include a plan view from the Z direction and a corresponding cross-sectional view taken through line A-A' of each plan view for various processes during the method of manufacturing the memory device 100.

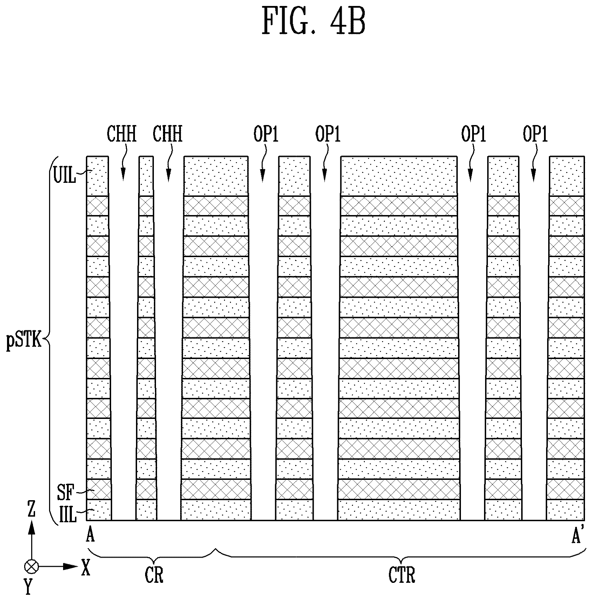

Referring to FIG. 4A and FIG. 4B, a preliminary stack structure pSTK is formed including interlayer insulating layers IIL and sacrificial layers SF stacked alternately. The upper insulating layer UIL is stacked over the interlayer insulating layers IIL and the sacrificial layers SF. The interlayer insulating layers IIL may include an insulating material. For example, the interlayer insulating layers IIL may include an oxide layer, for example, a silicon oxide layer. The upper insulating layer UIL may include the same material as the interlayer insulating layers IIL. The sacrificial layers SF include a material that can be selectively removed. The sacrificial layers SF may include a material having an etching selectivity different from the etching selectivity of the interlayer insulating layers IIL. For example, the sacrificial layers SF may include a nitride layer.

Channel openings CHH and first openings OP1 extending through the preliminary stack structure pSTK are formed. The channel openings CHH extend through the cell region CR of the preliminary stack structure pSTK. The first openings OP1 extend through the contact region CTR of the preliminary stack structure pSTK. Each of the channel openings CHH and the first openings OP1 may have a rounded shape. For example, the channel openings CHH and the first openings OP1 may have a circular or elliptical shape in an XY plane.

The channel openings CHH and the first openings OP1 may be formed simultaneously or during the same process. For example, the channel openings CHH and the first openings OP1 may be formed during a single etching process. The first openings OP1 may be formed simultaneously with the channel openings CHH using an etching process in which openings having a high aspect ratio are simultaneously etched. The cost and time utilized during the etching process may be reduced by etching the openings having a high aspect ratio at the same time. An anisotropic dry etching process may be performed to form the channel openings CHH and the first openings OP1.

In an embodiment, the channel openings CHH and the first openings OP1 have equal areas in the same XY plane. In an embodiment, the channel openings CHH and the first openings OP1 have different areas in the same XY plane.

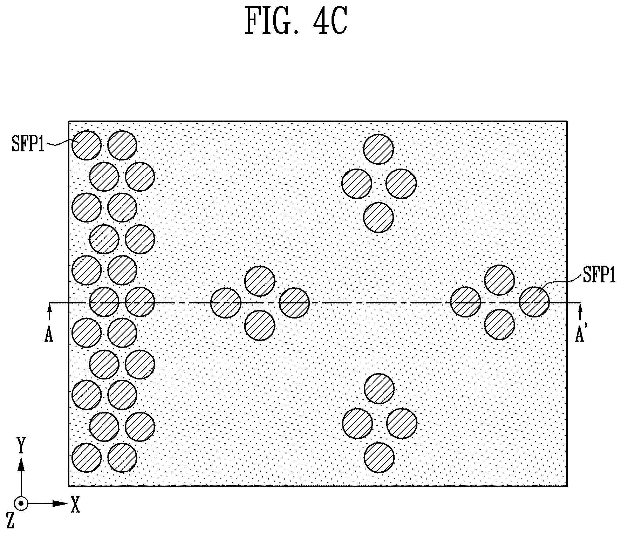

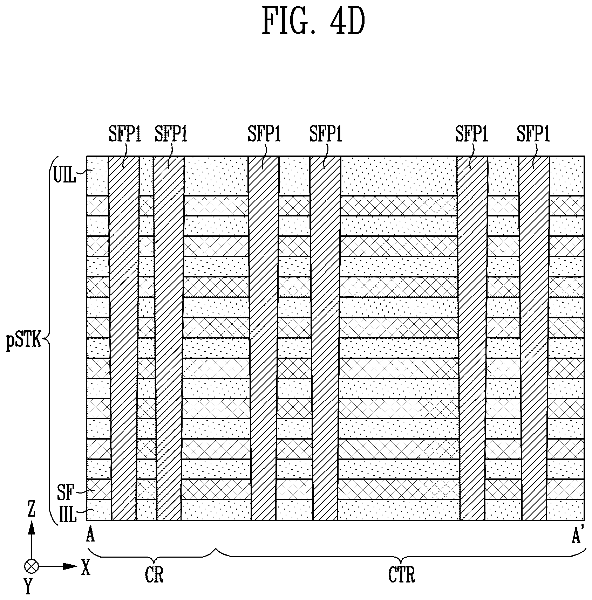

Referring to FIG. 4C and FIG. 4D, first sacrificial pillars SFP1 are formed in the channel openings CHH and the first openings OP1. The first sacrificial pillars SFP1 may fill the channel openings CHH and the first openings OP1. The first sacrificial pillars SFP1 may include a carbon layer. For example, the first sacrificial pillars SFP1 may include a carbon layer, may include a carbon layer and polysilicon, or may include a carbon layer and a metal nitride, such as TiN.

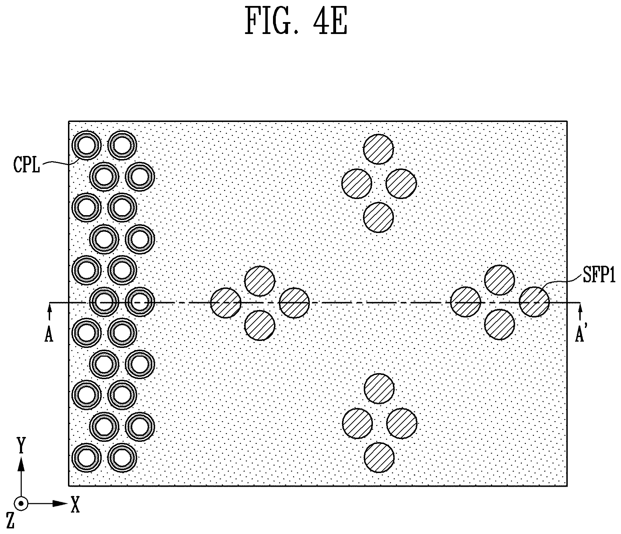

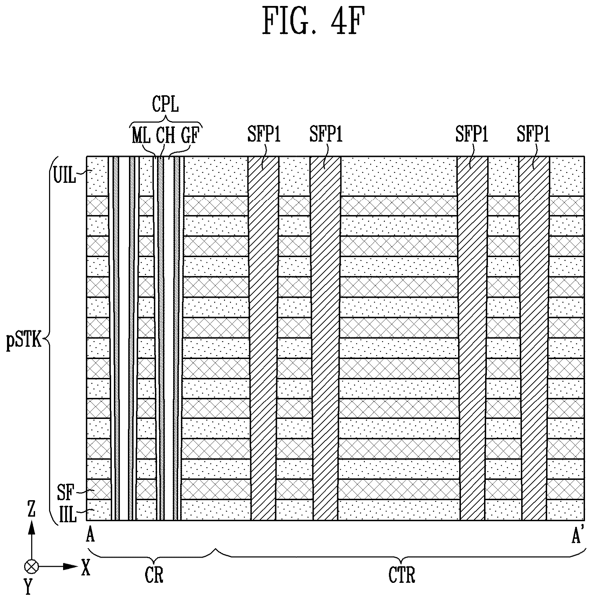

Referring to FIG. 4E and FIG. 4F, the first sacrificial pillars SFP1 in the channel openings CHH are removed. The cell plugs CPL are formed in the channel openings CHH. The memory layer ML, the channel layer CH, and the gap-fill layer GF are sequentially formed along inner surfaces of the preliminary stack structure pSTK, which inner surfaces are adjacent to the channel openings CHH.

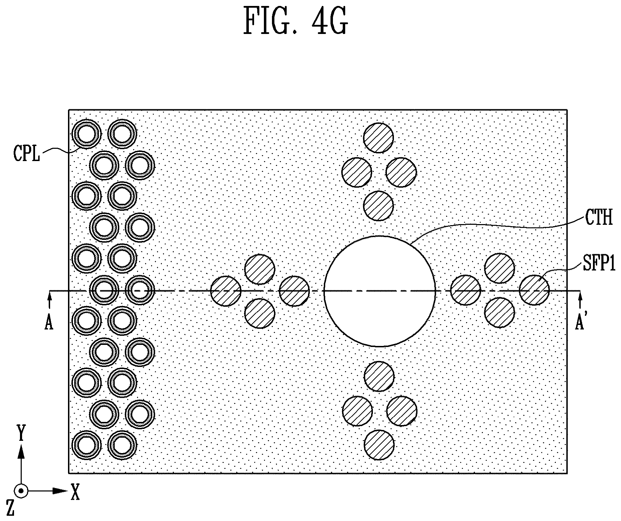

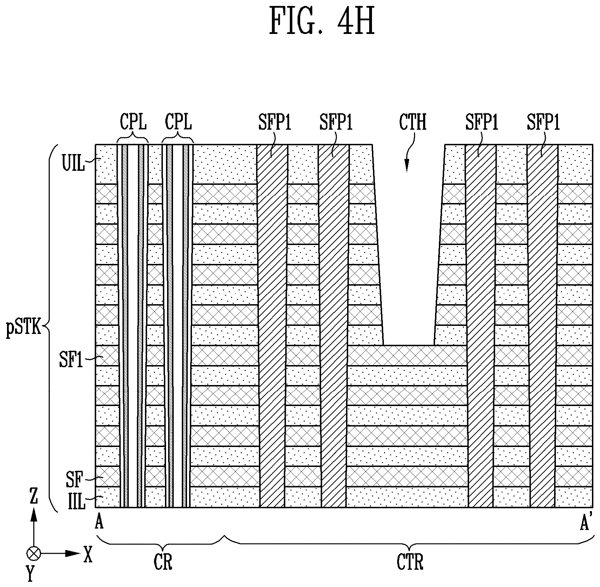

Referring to FIG. 4G and FIG. 4H, a contact opening CTH is formed in the contact region CTR of the preliminary stack structure pSTK. A first sacrificial layer SF1 among the sacrificial layers SF is exposed through the contact opening CTH. The contact opening CTH extends from the first sacrificial layer SF1 in the Z direction. An upper surface of the first sacrificial layer SF1 is exposed through the contact opening CTH.

Processes including alternately removing the interlayer insulating layers IIL and the sacrificial layers SF may be performed to form the contact opening CTH. Processes including sequentially etching the oxide layer and the nitride layer may be performed such that the contact opening CTH is formed at a specific depth, such as a depth corresponding to the first sacrificial layer SF1. The planar area of the contact opening CTH may be larger than the planar area of the channel openings CHH or the first openings OP1 at the same level in the Z direction because etching processes are performed multiple times.

The contact openings CTH are spaced apart from the first openings OP1. The first sacrificial pillars SFP1 in the first openings OP1 are not exposed through the contact opening CTH.

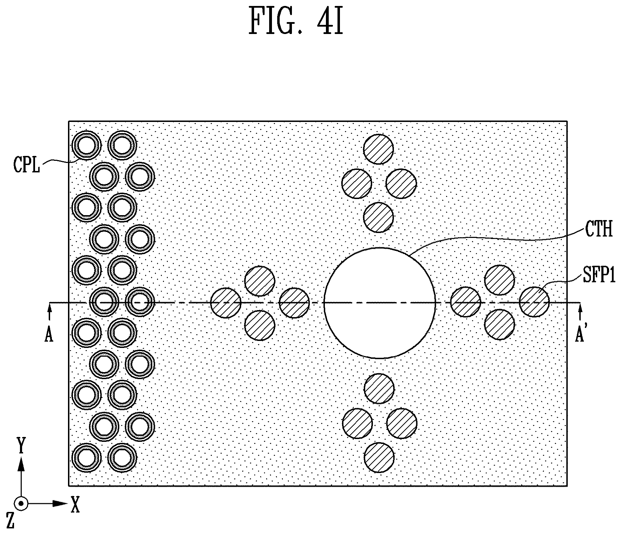

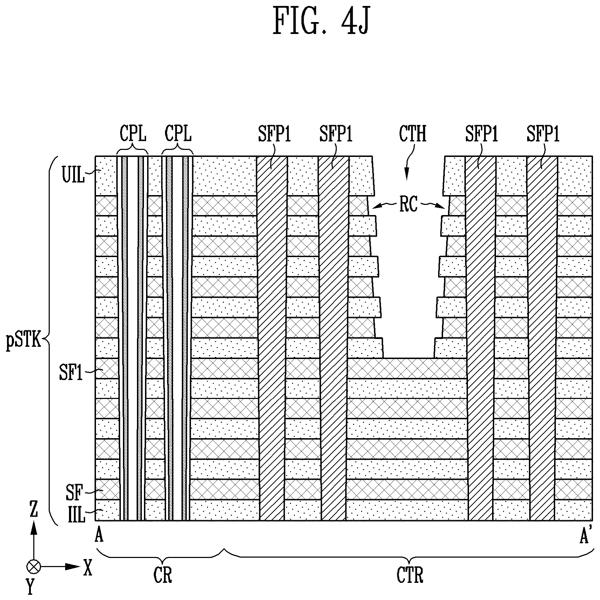

Referring to FIG. 4I and FIG. 4J, sections of the sacrificial layers SF are etched through the contact opening CTH. Recesses RC are formed by etching sections of sides of the sacrificial layers SF exposed through the contact opening CTH. To prevent defects caused by coupling of the conductive layers CD arranged in the Z direction, the sacrificial layers SF exposed through the contact openings CTH include recesses in the X direction. An upper surface of the first sacrificial layer SF1 may be further etched than shown in FIG. 4J.

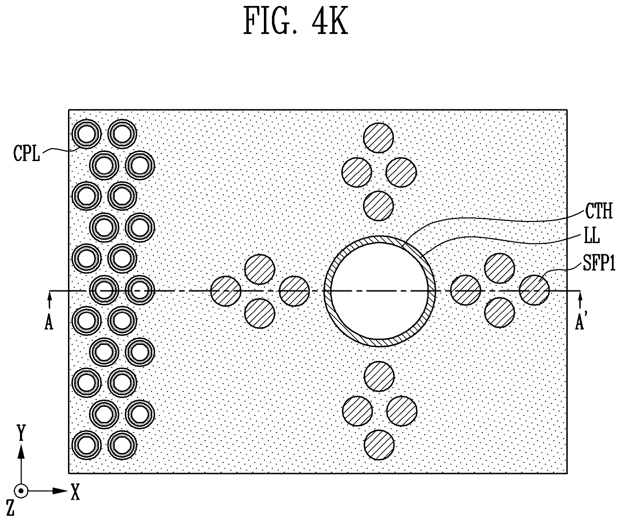

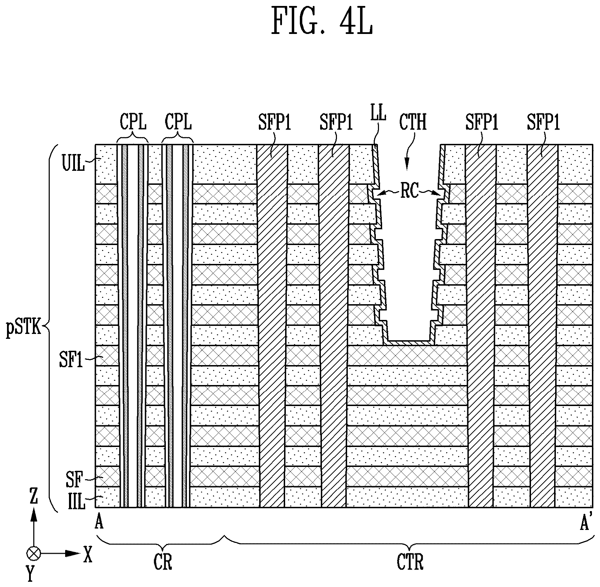

Referring to FIG. 4K and FIG. 4L, a liner layer LL is formed along an inner surface of the preliminary stack structure pSTK, which inner surface is adjacent to the contact opening CTH. The liner layer LL extends along a side surface of the preliminary stack structure pSTK being adjacent to the contact opening CTH and an upper surface of the first sacrificial layer SF1 adjacent to the contact opening CTH. The liner layer LL is formed on sides of the preliminary stack structure pSTK exposed through the contact opening CTH. The liner layer LL is conformally formed along the recesses RC of the sacrificial layers SF and along the interlayer insulating layers IIL. The liner layer LL may include at least one material including TiN, SiCN, or polysilicon.

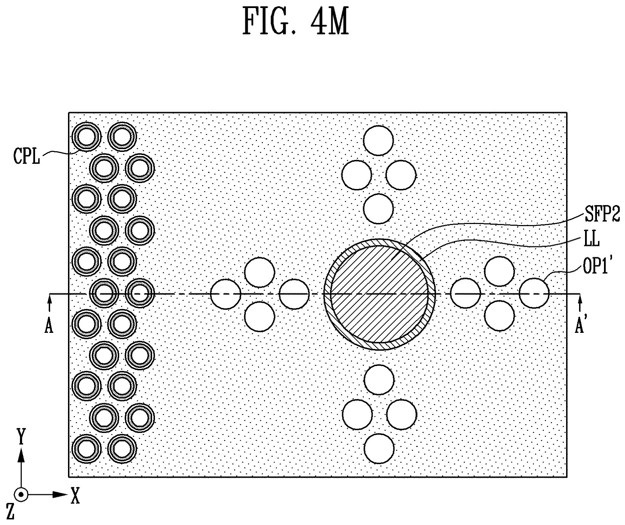

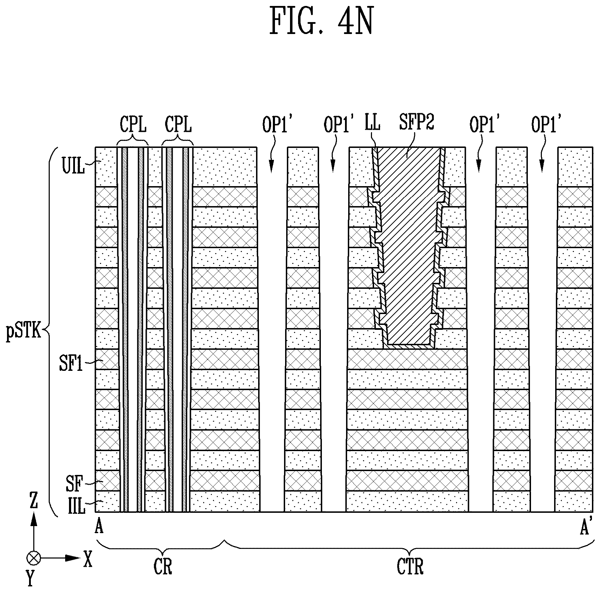

Referring to FIG. 4M and FIG. 4N, a second sacrificial pillar SFP2 is formed in the liner layer LL formed in the contact opening CTH. The second sacrificial pillar SFP2 fills the liner layer LL formed in the contact opening CTH. The second sacrificial pillar SFP2 is surrounded by the liner layer LL. The second sacrificial pillar SFP2 is separated or insulated from the preliminary stack structure pSTK by the liner layer LL. The second sacrificial pillar SFP2 may include at least one of a carbon layer or polysilicon.

The first sacrificial pillars SFP1 formed in the first openings OP1 are removed. As the first sacrificial pillars SFP1 are removed, the first openings OP1' are formed in substantially the same location as the first openings OP1. The first openings OP1' are located around the contact opening CTH.

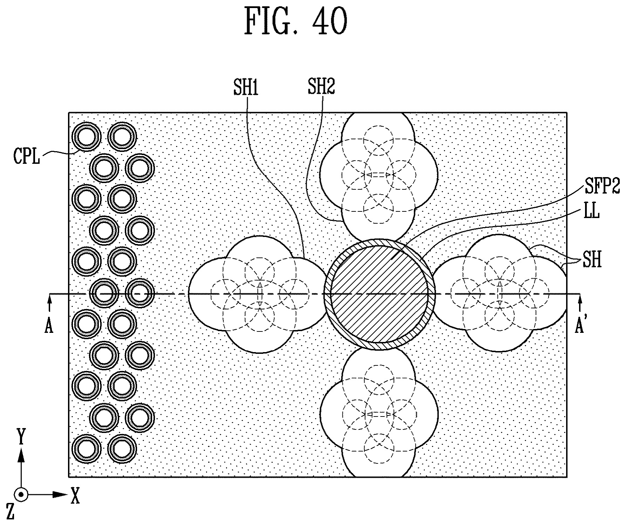

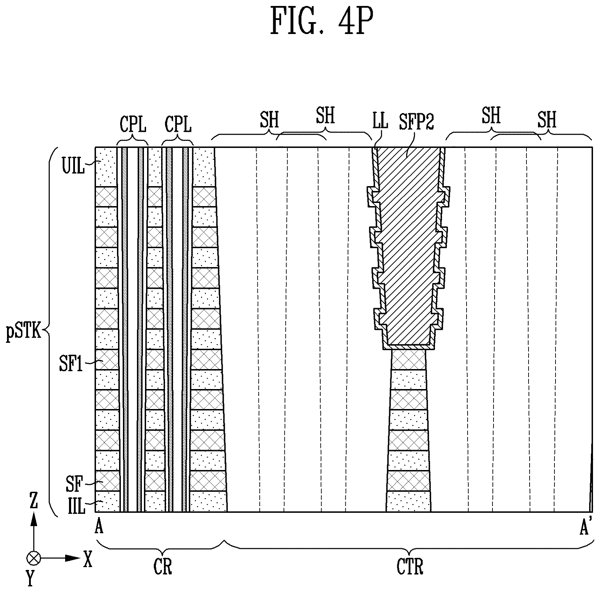

Referring to FIG. 4O and FIG. 4P, each of the first openings OP1' is expanded to form a support hole SH. Sections of the interlayer insulating layers IIL and the sacrificial layers SF of the preliminary stack structure pSTK are removed through the first openings OP1'. Side surfaces of the interlayer insulating layers IIL and the side surfaces of the sacrificial layers SF exposed through the first openings OP1' are etched such that the first openings OP1' are expanded. To expand the volume of the first openings OP1', a wet etching process or a dry etching process may be performed.

Because the first openings OP1' are expanded, the support holes SH overlap. For example, as the sidewalls of the interlayer insulating layers IIL and the sacrificial layers SF located between the first openings OP1' are gradually etched, the sidewalls between the support holes SH is removed. Each group of support holes SH overlaps and forms a single space. For example, the support holes SH formed by expanding a group of four first openings OP1' extending in the X direction from the liner layer LL formed in the contact opening CTH form one space. FIG. 4O shows four groups including four support holes SH radially extending from the liner layer LL formed in the contact opening CTH and separated by 90 degrees. The planar shape of one group of the overlapping support holes SH may be a shape in which several circles or ellipses overlap. The extent to which the first openings OP1' are expanded, for example, time, etchant concentration, and so forth, is controlled such that the support holes SH overlap each other. For example, the degree of expansion of the first openings OP1' is determined such that a first group of support holes SH extending in the X direction from the liner layer LL formed in the contact opening CTH overlap, and the first group of support holes SH does not overlap with the other groups of support holes SH, such as the groups of support hole SH extending in the Y direction from the liner layer LL formed in the contact opening CTH.

When the first openings OP1' are expanded, the liner layer LL may be used as an etching stop layer. The support holes SH do not extend past the liner layer LL into the second sacrificial pillar SFP2 formed in the contact opening CTHL. A side surface of the liner layer LL is exposed through the support holes SH. As shown in FIG. 4L, the liner layer LL is formed over the inner surface of the preliminary stack structure pSTK being adjacent to the contact opening CTH to separate the contact opening CTH from the support holes SH.

The first openings OP1' are expanded such that the support holes SH expose a lower surface of the liner layer LL formed in the contact opening CTH. The support holes SH extend towards a bottom of the liner layer LL formed in the contact opening CTH. The support holes SH may partially overlap the liner layer LL formed in the contact opening CTH in the Z direction. The distance between a support hole SH1 extending in the X direction from and contacting the liner layer LL formed in the contact opening CTH and a support hole SH2 extending in the Y direction from and contacting the liner layer LL formed in the contact opening CTH is smaller than the diameter of the contact opening CTH in the X direction. To improve support effectiveness of the support structure, such as the support structure SS of FIG. 3A and FIG. 3B, to be disposed in the support holes SH, the support holes SH extend below the bottom of the liner layer LL formed in the contact opening CTH. Thus, an area of a lower surface of the liner layer LL is exposed through the support holes SH.

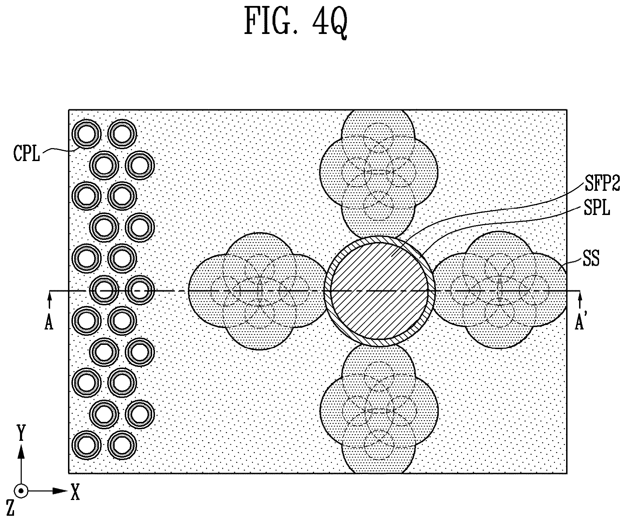

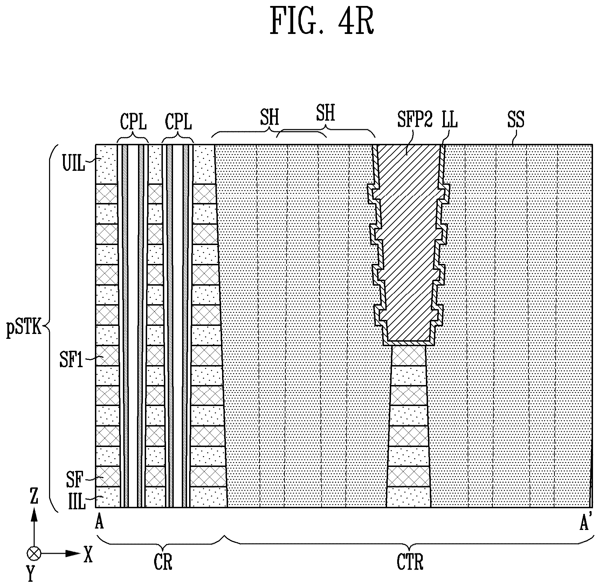

Referring to FIG. 4Q and FIG. 4R, a support structure SS is formed in each group of overlapping support holes SH. The support structures SS may include insulating layers disposed or filled in the support holes SH that overlapping. Each of the support structures SS may be formed by depositing an oxidizing material in a thermal atomic layer deposition ALD method in the overlapping support holes SH overlapping.

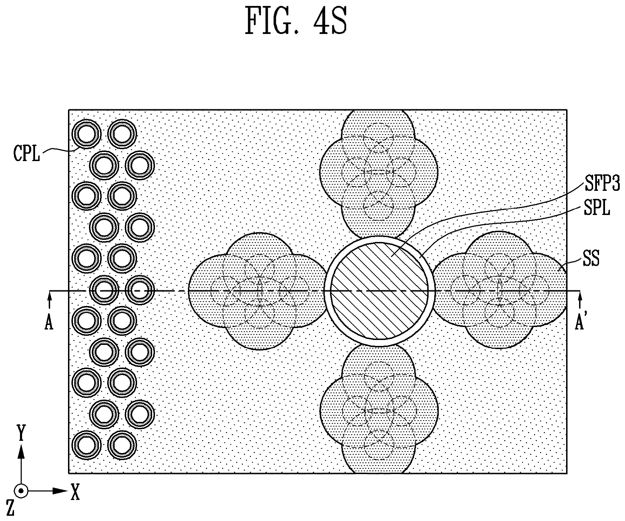

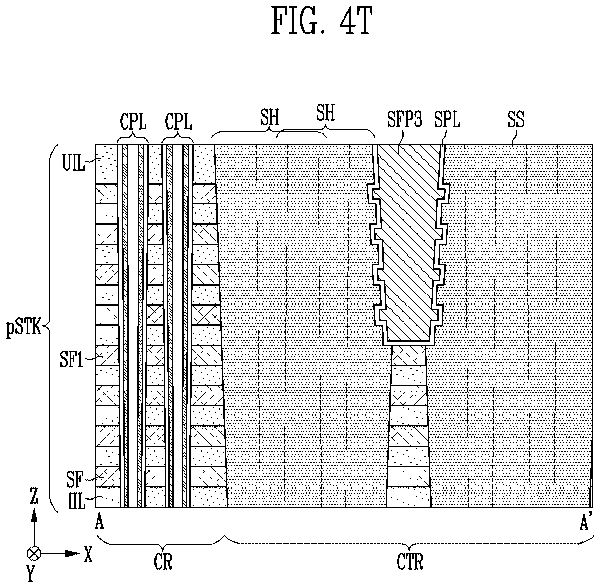

Referring to FIG. 4S and FIG. 4T, the second sacrificial pillar SFP2 and the liner layer LL are removed to form a new contact opening in a location identical to the contact opening CTH. A spacer layer SPL is formed along the inner surface of the preliminary stack structure pSTK, which inner surface is adjacent to the new contact opening CTH. The spacer layer SPL extends along the side surface of the preliminary stack structure pSTK being adjacent to the new contact opening, and an upper surface of the first sacrificial layer SF1 adjacent to the new contact opening. The spacer layer SPL may include an insulating material. For example, the spacer layer SPL may include an oxide layer. A third sacrificial pillar SFP3 is formed in the new contact opening. The third sacrificial pillar SFP3 is separated from the preliminary stack structure pSTK by the spacer layer SPL. The third sacrificial pillar SFP3 may include a carbon layer.

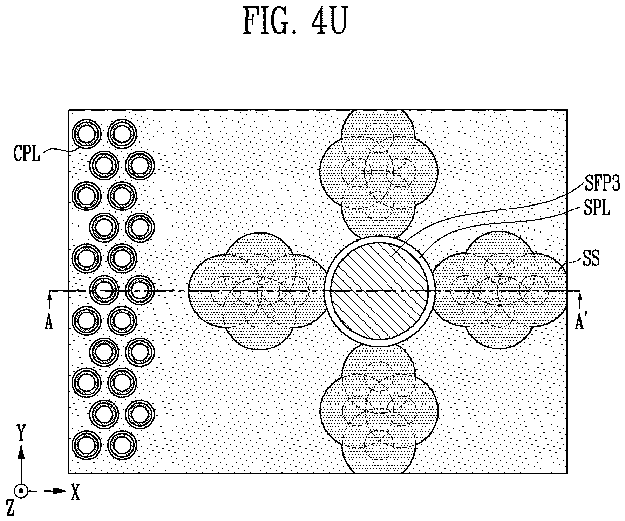

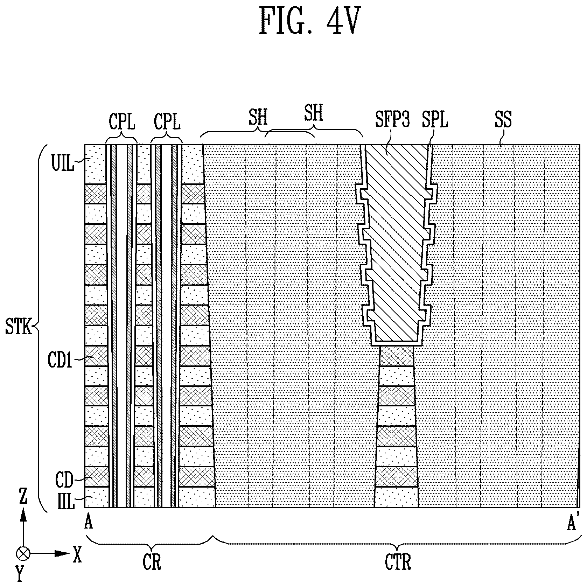

Referring to FIG. 4U and FIG. 4V, the sacrificial layers SF of the preliminary stack structure pSTK are removed. The sacrificial layers SF may be etched through a slit (not shown) that extends through the preliminary stack structure pSTK. As the sacrificial layers SF are removed, an empty space is formed between consecutive interlayer insulating layers IIL. According to the present disclosure, because the support structures SS support the interlayer insulating layers IIL in a spaced apart arrangement, bending of the interlayer insulating layers IL may be reduced. For example, as the planar area of the contact opening CTH increases, the risk of bending of the interlayer insulating layers IIL located below the contact opening CTH increases. According to embodiments of the present disclosure, because the support structures SS extend below the contact openings CTH, support effectiveness of the support structures SS may be improved.

The conductive layers CD are formed in the spaces formed by removal of the sacrificial layers SF. The conductive layers CD may fill space between consecutive interlayer insulating layers IIL. The sacrificial layers SF are replaced with the conductive layers CD. For example, the first sacrificial layer SF1 is replaced with the first conductive layer CD1.

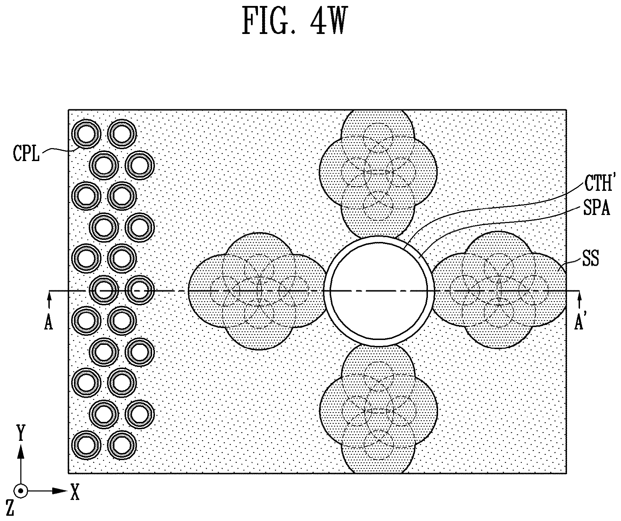

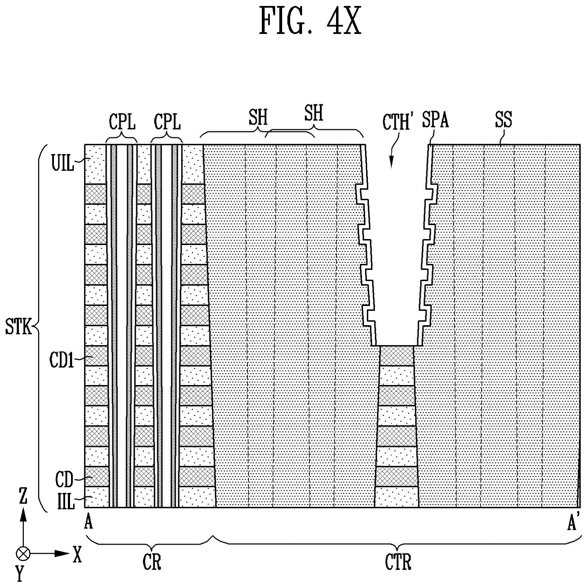

Referring to FIG. 4W and FIG. 4X, the third sacrificial pillar SFP3 formed in the new contact opening is removed, forming a contact opening CTH'. A lower surface of the spacer layer SPL is removed to form the spacer SPA. The spacer SPA extends along an inner side surface of the stack structure STK adjacent to the contact opening CTH'. Because the lower surface of the spacer layer SPL is removed, the upper surface of the first conductive layer CD1 is exposed through the contact opening CTH'. A surface of the support structures SS may be exposed through the contact openings CTH'.

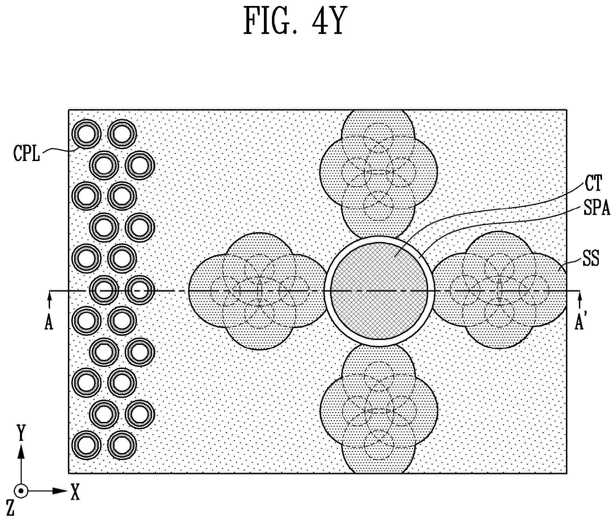

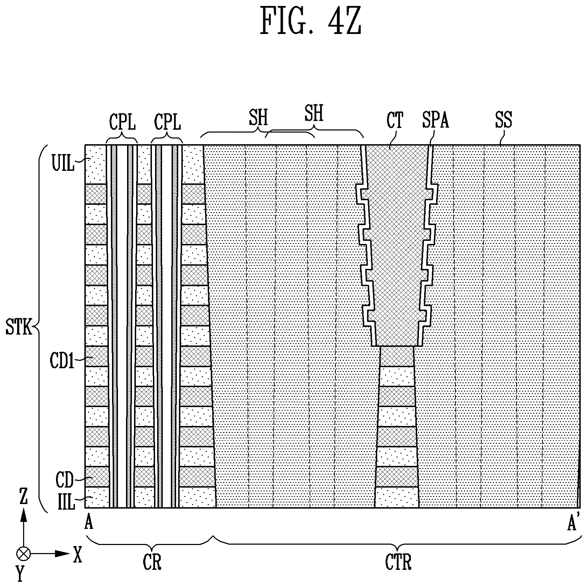

Referring to FIG. 4Y and FIG. 4Z, the contact CT is formed in the contact opening CTH'. For example, the contact CT may be formed by filling the contact opening CTH' with a conductive material. The contact CT is electrically coupled to the first conductive layer CD1.

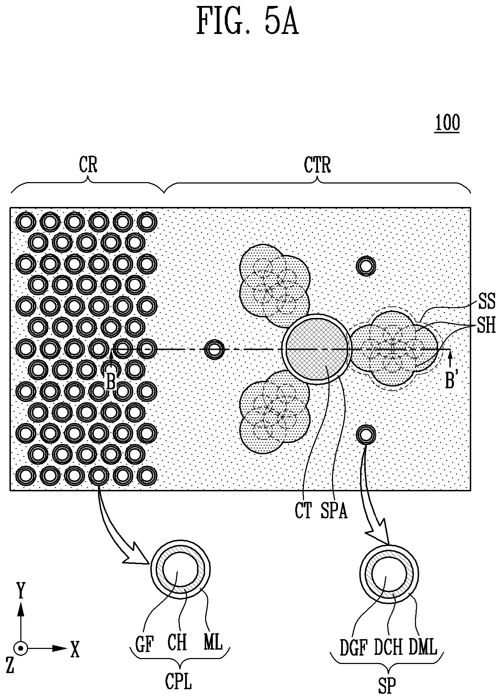

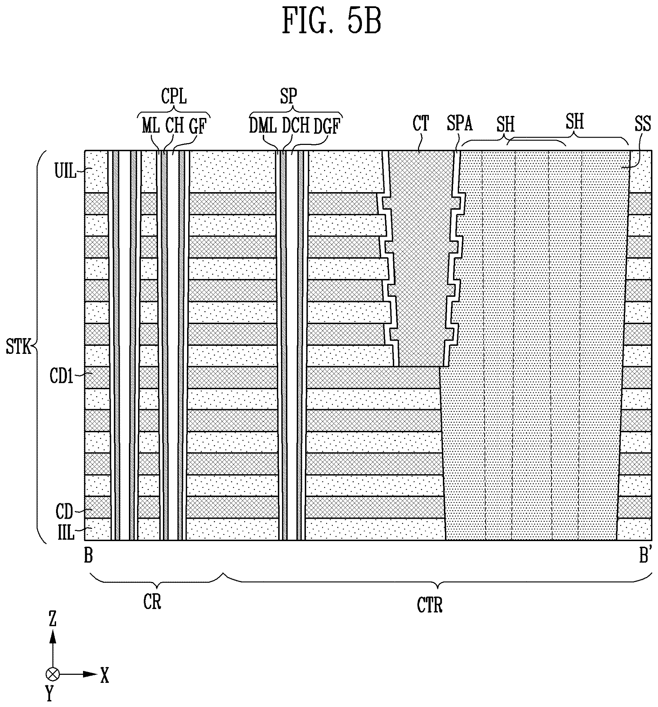

FIG. 5A and FIG. 5B are diagrams illustrating the memory device 100 including the support structure SS and the support pillar SP according to an embodiment of the present disclosure. FIG. 5A is a plan view illustrating a layout of the memory device 100 according to an embodiment of the present disclosure. FIG. 5B shows a cross-section taken along line B-B' of FIG. 5A.

Various structures and configurations of FIG. 5A and FIG. 5B are similar to the structures and configurations described and shown in FIG. 3A and FIG. 3B.

Referring to FIG. 5A and FIG. 5B, the memory device 100 includes the cell plugs CPL. The cell plugs CPL are disposed in the cell region CR. The cell plugs CPL extend through the cell region CR of the stack structure STK. Each of the cell plugs CPL includes the memory layer ML, the channel layer CH, and the gap-fill layer GF.

The memory device 100 includes the contact CT and the spacer SPA disposed in the contact region CTR. The contact CT contacts the first conductive layer CD1 among the conductive layers CD of the stack structure STK. The contact CT is electrically coupled to the first conductive layer CD1. The spacer SPA insulates the contact CT from conductive layers CD other than the first conductive layer CD1.

The memory device 100 includes the support structures SS disposed around the contact CT. The support structures SS extend through the contact region CTR of the stack structure STK. The support structures SS contact the outer surface of the spacer SPA. The support structures SS contact the lower surface of the contact CT.

In an embodiment, three support structures SS are disposed around the contact CT. Each of the support structures SS includes two or more support holes SH that overlap. Each of the support structures SS includes an insulating layer disposed or filled in the overlapping support holes SH. The support structures SS are not limited to FIG. 5A and FIG. 5B and the associated text.

Compared to the example where four or more support structures SS are disposed around the contact CT, in the example where three support structures SS are arranged, the distance between the support structures SS is larger. For example, three support structures SS are separated by 120 degrees, whereas four support structures are separated by 90 degrees. When three support structures SS are disposed around the contact CT, support pillars SP may be disposed between consecutive support structures SS. For example, three support pillars SP may be disposed between the three support structures SS as shown in FIG. 5A.

The support pillars SP are arranged in the contact area CTR. The support pillars SP extend in the Z direction within the stack structure STK. The support pillars SP extend through the contact area CTR of the stack structure STK. The support pillars SP are spaced apart from the contact CT, the spacer SPA, and the support structures SS. The support pillars SP and the cell plugs CPL may have equal areas in the same XY plane.

The support pillars SP have a structure similar to the cell plug CPL in the example of FIG. 5A and FIG. 5B. The support pillars SP include a dummy memory layer DML, a dummy channel layer DCH, and a dummy gap-fill layer DGF. The dummy memory layer DML may have a cylindrical shape. The dummy memory layer DML surrounds the dummy channel layer DCH. Although not shown, the dummy memory layer DML includes a dummy blocking layer, a dummy charge trap layer, and a dummy tunnel insulating layer. The dummy channel layer DCH is formed along an inner wall of the dummy memory layer DML. The dummy gap-fill layer DGF fills the dummy channel layer DCH. The dummy gap-fill layer DGF may have a cylindrical shape surrounded by the dummy channel layer DCH.

The dummy blocking layer, the dummy charge trapping layer, and the dummy tunnel insulating layer included in the dummy memory layer DML may include the same material as the blocking layer, the charge trapping layer and the tunnel insulating layer included in the memory layer ML, respectively. The dummy channel layer DCH may include the same material as the channel layer CH. The dummy gap-fill layer DGF may include the same material as the gap-fill layer.

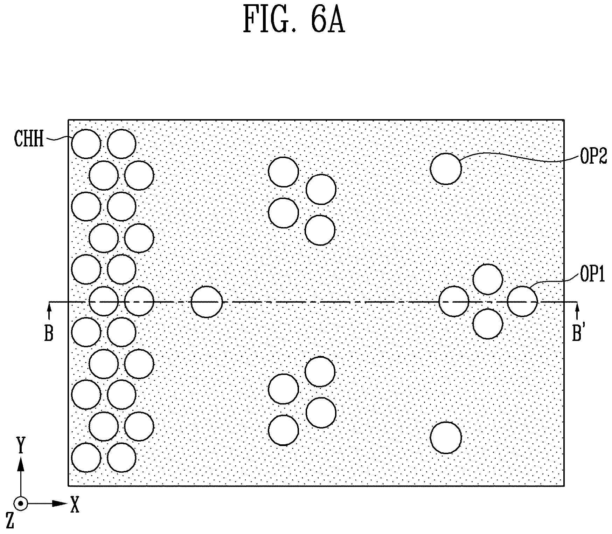

FIG. 6A to FIG. 6N are diagrams illustrating views of a memory device including a support structure and a support pillar formed utilizing a method of manufacturing the memory device 100 including support structures SS and support pillars SP according to an embodiment of the present disclosure. FIG. 6A to FIG. 6N include a plan view from the Z direction and a corresponding cross-sectional view taken through the line B-B' of each plan view for various processes during the method of manufacturing the memory device 100.

Various structures and configurations of FIG. 6A to FIG. 6N are similar to the structures and configurations described and shown in FIG. 4A to FIG. 4Z.

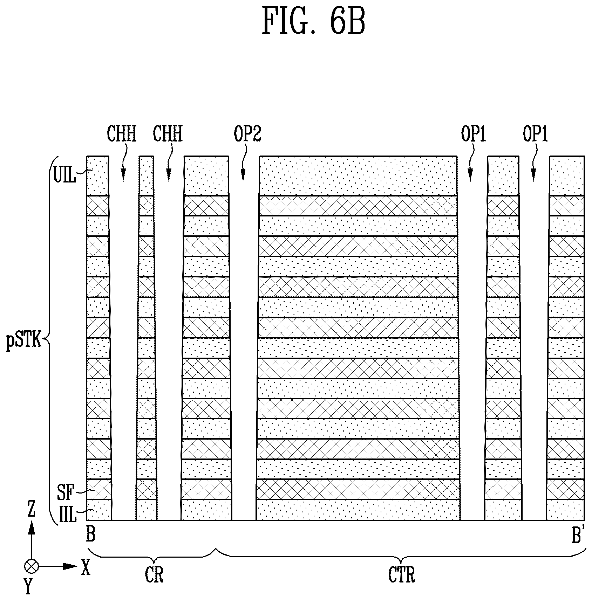

Referring to FIG. 6A and FIG. 6B, the preliminary stack structure pSTK is formed including interlayer insulating layers IIL and sacrificial layers SF stacked alternately. The upper insulating layer UIL is stacked over the interlayer insulating layers IIL and the sacrificial layers SF.

The channel openings CHH, the first openings OP1, and the second openings OP2 extending through the preliminary stack structure pSTK are formed. The channel openings CHH extend through the cell region CR of the preliminary stack structure pSTK. The first openings OP1 and the second openings OP2 extend through the contact region CTR of the preliminary stack structure pSTK. The channel openings CHH, the first openings OP1, and the second openings OP2 may have a rounded shape. For example, the channel openings CHH, the first openings OP1, and the second openings OP2 may have a circular or elliptical shape in an XY plane.

The channel openings CHH, the first openings OP1, and the second openings OP2 may be formed simultaneously or during the same process. For example, the channel openings CHH, the first openings OP1, and the second openings OP2 may be formed during a single etching process. Using an etching process in which openings having a high aspect ratio are simultaneously etched, the first openings OP1 and the second openings OP2 are formed simultaneously with the channel openings CHH. The cost and time required for the etching process may be reduced by etching the openings having a high aspect ratio at the same time. An anisotropic dry etch process may be performed to form the channel openings CHH, the first openings OP1, and the second openings OP2.

In an embodiment, the channel openings CHH, the first openings OP1, and the second openings OP2 may have equal planar areas. In an embodiment, the channel openings CHH, the first openings OP1, and the second openings OP2 may have different areas in the same XY plane.

The distance between the second openings OP2 is farther than the distance between the channel openings CHH. The distance between the second openings OP2 is greater than the distance between consecutive first openings OP1.

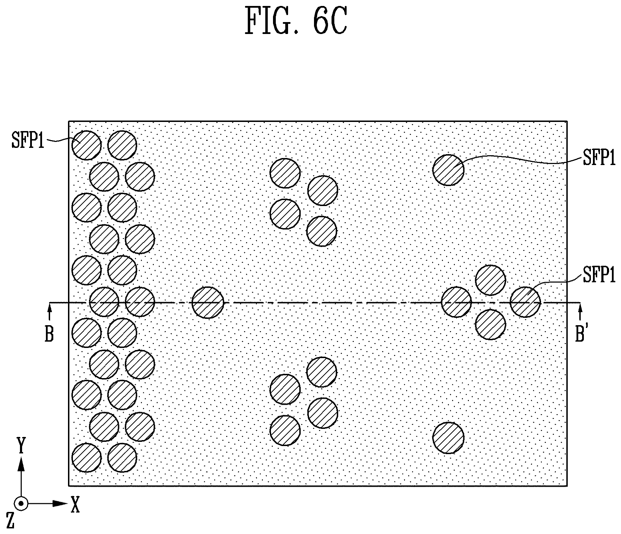

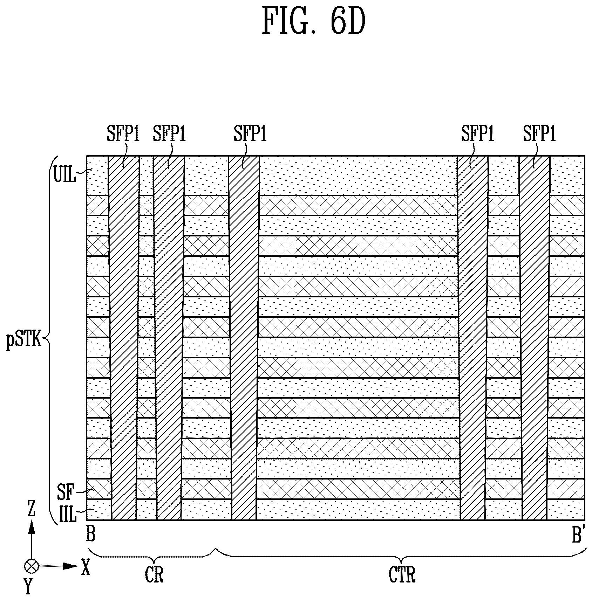

Referring to FIG. 6C and FIG. 6D, the first sacrificial pillars SFP1 are formed in the channel openings CHH, the first openings OP1, and the second openings OP2. The first sacrificial pillars SFP1 may fill the channel openings CHH, the first openings OP1, and the second openings OP2. The first sacrificial pillars SFP1 may include a carbon layer. For example, the first sacrificial pillars SFP1 may include a carbon layer, may include a carbon layer and polysilicon, or may include a carbon layer and a metal nitride, such as TiN.

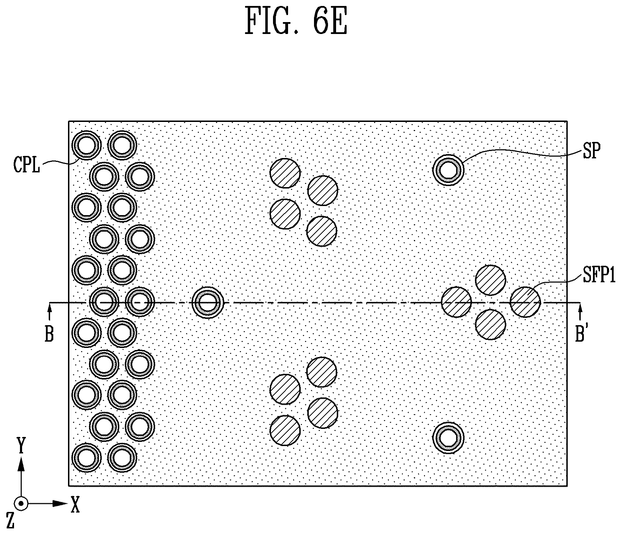

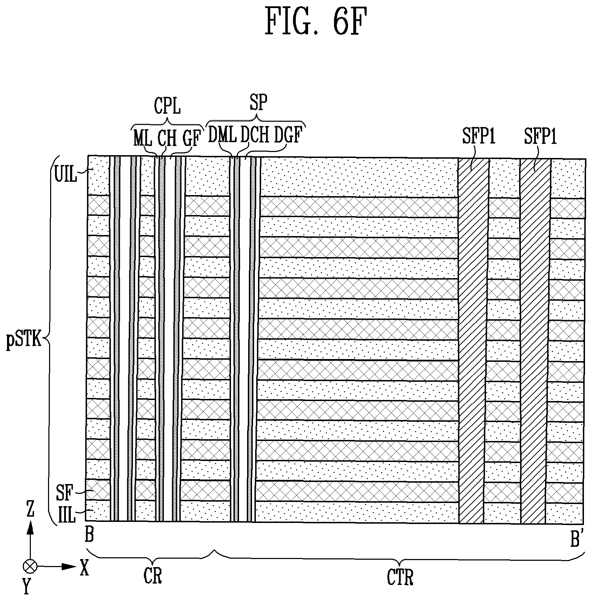

Referring to FIG. 6E and FIG. 6F, the first sacrificial pillars SFP1 in the channel openings CHH are removed. The first sacrificial pillars SFP1 in the second openings OP2 are removed. The process of removing the first sacrificial pillars SFP1 from the channel openings CHH and the second openings OP2 may be performed simultaneously. For example, the first sacrificial pillars SFP1 may be etched using an isotropic wet etching process.

The cell plugs CPL and the support pillars SP may be formed in the channel openings CHH and the second openings OP2, respectively. When the cell plugs CPL are formed in the channel openings CHH, the support pillars SP may be simultaneously formed in the second openings OP2.

For example, the memory layer ML is formed along inner side surfaces of the preliminary stack structure pSTK being adjacent to the channel openings CHH. The dummy memory layer DML is formed along inner side surfaces of the preliminary stack structure pSTK being adjacent to the second openings OP2. The dummy memory layer DML may include the same materials as the memory layer ML. The dummy memory layer DML and the memory layer ML may be simultaneously formed. For example, after a preliminary blocking layer, a preliminary charge trap layer, and a preliminary tunnel insulating layer are formed over the preliminary stack structure pSTK, a portion of the preliminary blocking layer, a portion of the preliminary charge trap layer, and a portion of the preliminary tunnel insulating layer located on the preliminary stack structure pSTK are removed. The remaining preliminary blocking layer, the remaining preliminary charge trap layer, and the remaining preliminary tunnel insulating layer formed in the channel openings CHH forms the memory layer ML. The preliminary blocking layer, the preliminary charge trap layer, and the preliminary tunnel insulating layer remaining in the second openings OP2 forms the dummy memory layer DML.

The channel layer CH is formed in the channel openings CHH. The dummy channel layer DCH is formed in the second openings OP2. The channel layer CH is formed on an inner side surface of the memory layer ML, and the dummy channel layer DCH is formed on an inner side surface of the dummy memory layer DML. The dummy channel layer DCH may include the same material, such as silicon, as the channel layer CH. The dummy channel layer DCH may be formed simultaneously with forming the channel layer CH. For example, after polysilicon is formed over the preliminary stack structure pSTK on which the first opening OP1 and the second opening OP2 are formed, some of the polysilicon located over the preliminary stack structure pSTK may be removed. The polysilicon remaining in the channel openings CHH forms the channel layer CH, and the polysilicon remaining in the second openings OP2 forms the dummy channel layer DCH.

The gap-fill layer GF is formed within the channel layer, and the dummy gap-fill layer DGF is formed within the dummy channel layer DCH. The gap-fill layer GF is surrounded by the channel layer CH. The dummy gap-fill layer DGF is surrounded by the dummy channel layer DCH. The memory layer ML, the channel layer CH, and the gap-fill layer GF form the cell plug CPL. The dummy memory layer DML, the dummy channel layer DCH, and the dummy gap-fill layer DGF form the support pillar SP.

Various processes described with respect to FIG. 6A to FIG. 6N are similar to the processes described with respect to FIG. 4A to FIG. 4Z.

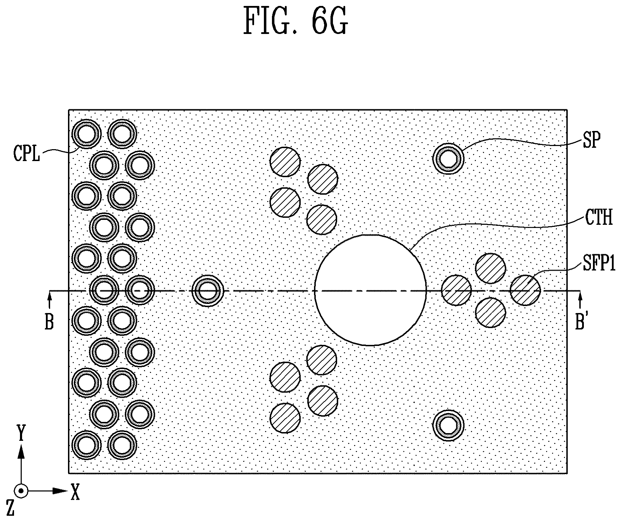

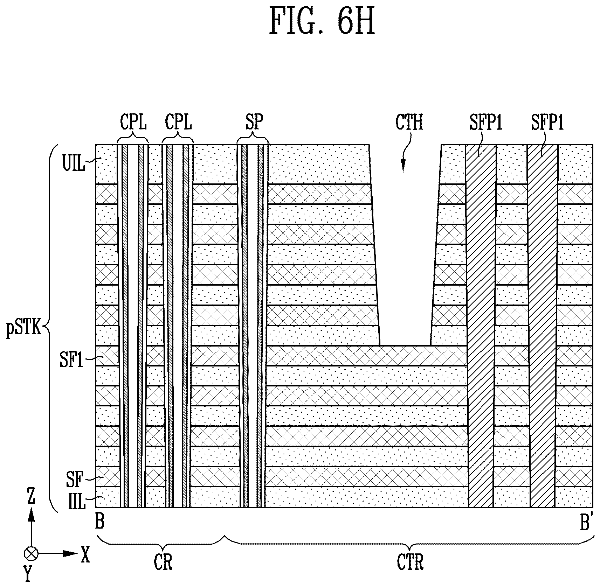

Referring to FIG. 6G and FIG. 6H, the contact opening CTH is formed in the contact region CTR of the preliminary stack structure pSTK. The first sacrificial layer SF of the sacrificial layers SF is exposed through the contact opening CTH. The area of the contact openings CTH is larger than each of the area of the channel openings CHH, the area of the first openings OP1, and the area of the second openings OP2 in the same XY plane. The contact opening CTH are spaced apart from the first openings OP1 and the support pillars SP.

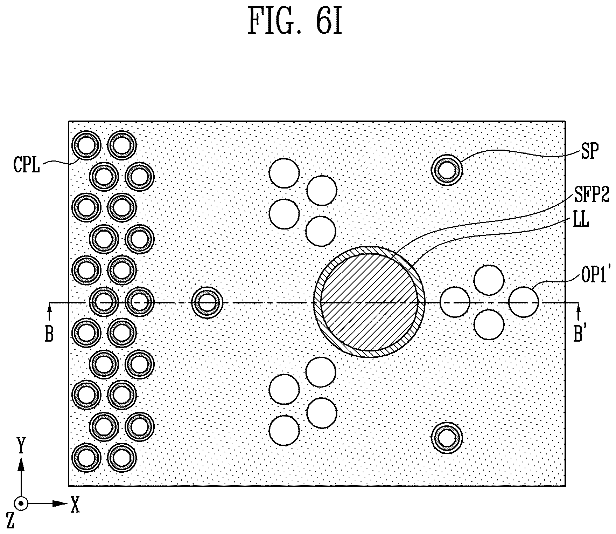

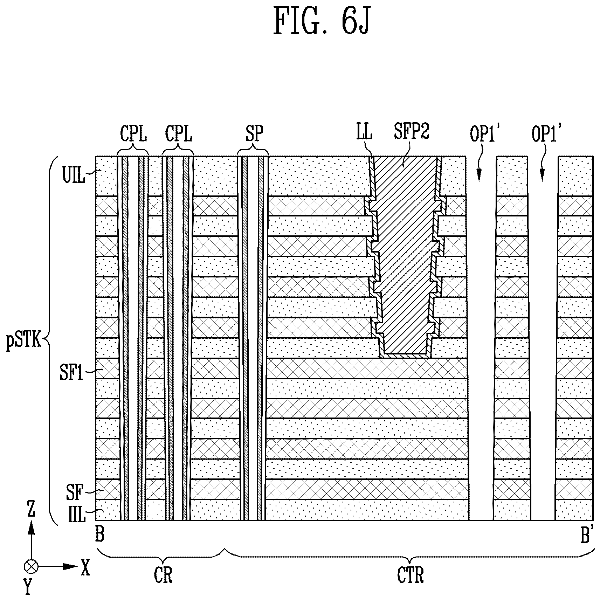

Referring to FIG. 6I and FIG. 6J, the sacrificial layers SF are etched through the contact opening CTH. The liner layer LL is formed along the inner surface of the preliminary stack structure pSTK adjacent to the contact opening CTH. The second sacrificial pillar SFP2 is formed in the liner layer LL formed in the contact opening CTH. The first sacrificial pillars SFP1 formed in the first openings OP1 are removed. As the first sacrificial pillars SFP1 are removed, the first openings OP1' are formed in substantially the same location as the first openings OP1.

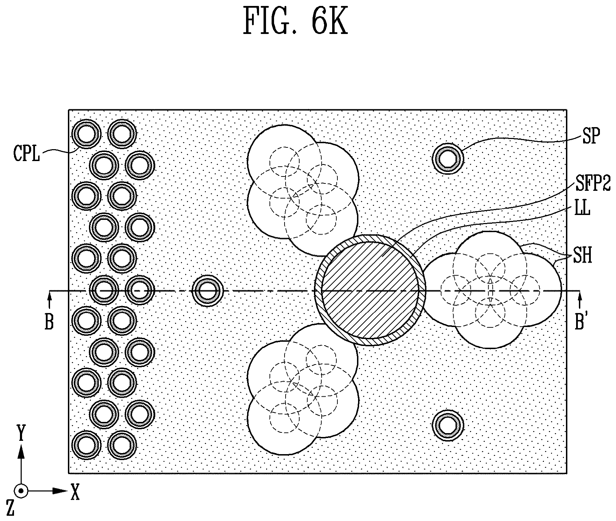

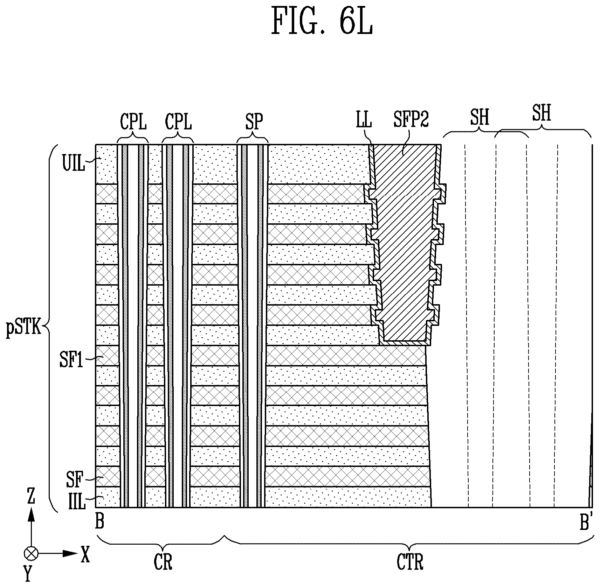

Referring to FIG. 6K and FIG. 6L, each of the first openings OP1' is expanded to form support holes SH. Sections of the interlayer insulating layers IIL and the sacrificial layers SF of the preliminary stack structure pSTK are removed through the first openings OP1'. Because the first openings OP1' are expanded, the support holes SH overlap. When the first openings OP1' are expanded, the liner layer LL may be used as an etching stop layer. The first openings OP1' are expanded such that the support holes SH expose the lower surface of the liner layer LL. The support holes SH extend towards the bottom of the liner layer LL formed in the contact opening CTH.

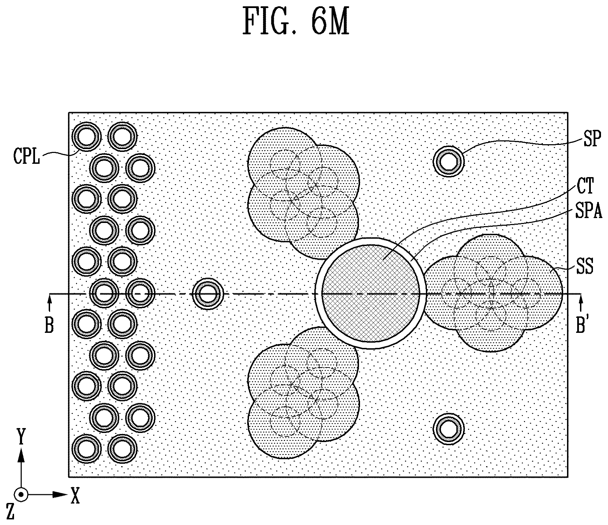

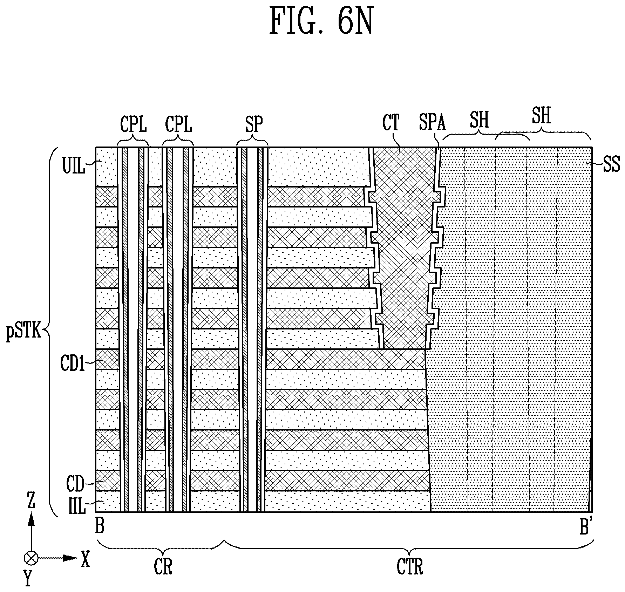

Referring to FIG. 6M and FIG. 6N, a support structure SS is formed in each group of overlapping support holes SH. The second sacrificial pillar SFP2 and liner layer LL are removed to form a new contact opening, and the spacer layer, for example, the spacer layer SPL of FIG. 4S, is formed in the new contact opening. The third sacrificial pillar, such as, the third sacrificial pillar SFP3 of FIG. 4S, is formed in the new contact opening.

The sacrificial layers SF of the preliminary stack structure pSTK are removed. As the sacrificial layers SF are removed, an empty space is formed between consecutive interlayer insulating layers IIL. According to the present disclosure, because the support structures SS and the support pillars SP support the interlayer insulating layers IIL in a spaced apart arrangement, bending of the interlayer insulating layers IL may be reduced.

The conductive layers CD are formed in the spaces formed by removal of the sacrificial layers SF. For example, the first sacrificial layer SF1 is replaced with the first conductive layer CD1.

The third sacrificial pillar SFP3 in the new contact opening is removed, forming a contact opening CTH', and the lower surface of the spacer layer SPL is removed. The contact CT surrounded by the spacer SPA is formed in the contact opening CTH'. The contact CT is electrically coupled to the first conductive layer CD1.

FIG. 7A to FIG. 7F are diagrams illustrating various support structures SS in accordance with embodiments of the present disclosure.

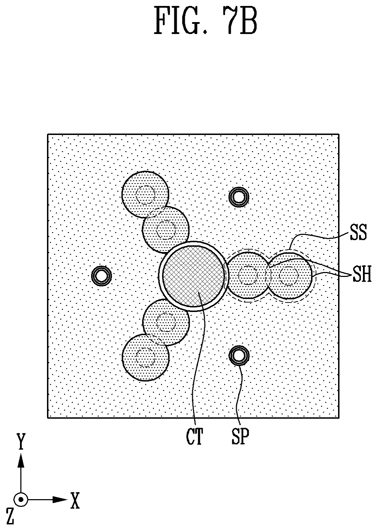

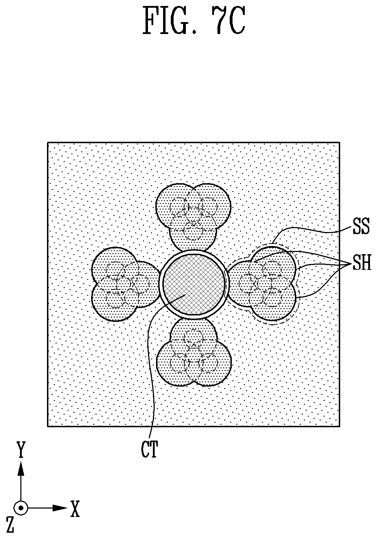

FIG. 7A and FIG. 7C illustrate various support structures SS when four support structures SS are disposed around the contact CT, such as shown in FIG. 3A. FIG. 7B and FIG. 7D illustrate various support structures SS when three support structures SS are disposed around the contact CT, such as shown in FIG. 5A. FIG. 7E illustrates various support structures SS in which the four support holes SH utilized to form the support structure SS overlap in different ways. FIG. 7F illustrates an embodiment in which four support holes SH utilized to form the support structures SS overlap consecutively.

Referring to FIG. 7A and FIG. 7B, each of the support structures SS are formed utilizing two support holes SH that overlap in a line radially extending from the contact CT. The two support holes SH utilized to form each of the support structures SS overlap radially or in a direction extending from a center of the contact CT. For example, the two overlapping support holes SH form a single space. The support holes SH may be formed by expanding the first openings, for example, the first openings OP1 in FIG. 4A and FIG. 6A. Sections of the stack structure STK might not remain between the two support holes SH.

The support holes SH are arranged in a direction extending away from the contact CT. The two overlapping support holes SH are arranged in a line. For example, the two support holes SH extending in the X direction from the contact CT are arranged in the X direction. The two support holes SH extending in the Y direction from the contact CT are arranged in the Y direction.

Referring to FIG. 7C and FIG. 7D, each of the support structures SS are formed utilizing three support holes SH that overlap. The three support holes SH that form each of the support structures SS overlap each other. For example, a common region may exist between two support holes SH among the three support holes SH. A common region may exist between all three support holes SH.

The centers of the support holes SH form vertices of a triangle in the examples of FIG. 7C and FIG. 7D. The centers of the three overlapping support holes SH may be arranged in a triangular shape where one support hole SH is adjacent to the contact CT and the other two support holes SH are disposed away from the contact CT, such that one vertex is closer to the contact CT than the other two vertices that are disposed farther from the contact CT. In an embodiment, the centers of the three overlapping support holes SH may be arranged in a triangular shape with where two support holes SH are adjacent to the contact CT and the third support hole SH is disposed away from the contact CT, such that two vertices are closer to the contact CT and one vertex is farther from the contact CT.

The descriptions in FIG. 7C and FIG. 7D are illustrative and the present disclosure is not limited to these examples. In an example, two support holes SH of the three support holes SH utilized to form each of the support structures SS overlap, and in another example, two support holes SH of the three support holes do not overlap. Each of the support structures SS may be formed utilized three overlapping support holes SH arranged in a line or row.

FIG. 7E illustrates various amounts of overlapping between the support holes SH utilized to form the support structure SS when four support holes SH overlap.

In an embodiment of FIG. 7E, such as shown in FIG. 3A and FIG. 5A, the support structure SS is formed utilizing four overlapping support holes SH. In this example, a common region may exist between any two consecutive support holes SH among the four support holes SH. In this example, a common region exists between any three support holes SH among the four support holes SH. In this example, a common region exists between all four support holes SH.

In an embodiment of FIG. 7E, a support structure SS' is formed utilizing four support holes SH that partially overlap. For example, common regions exist between any two consecutive support holes SH. Common regions exist between some but not all combinations of three support holes SH, and no common region exists between all four support holes in this example.

In an embodiment of FIG. 7E, the support structure SS'' is formed utilizing four support holes SH that partially overlap. For example, any two consecutive support holes SH overlap, although two opposing support holes SH do not overlap. No common regions exist between any combination of three support holes SH in this example. No common region exists between all four support holes SH in this example, and a section of the stack structure STK may remain between the four support holes SH.

FIG. 7F illustrates another arrangement where the support structure SS is formed utilizing four overlapping support holes SH. Referring to FIG. 7F, the support holes SH be arranged to surround the contact CT. The support holes SH are arranged in the shape of an arc adjacent to the contact CT, and only consecutive or adjacent support holes SH overlap. Any quantity or arrangement of overlapping support holes SH may be utilized to form a support structure SS.

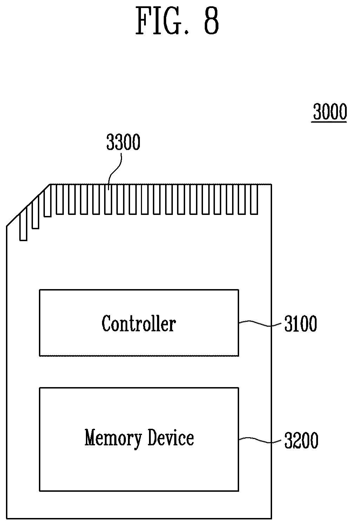

FIG. 8 is a diagram illustrating a memory card system 3000 including a memory device according to an embodiment of the present disclosure.

Referring to FIG. 8, the memory card system 3000 includes a controller 3100, a memory device 3200, and a connector 3300.

The controller 3100 is coupled to the memory device 3200. The controller 3100 is configured to access the memory device 3200. For example, the controller 3100 is configured to control a program operation, a read operation, an erase operation of the memory device 3200, and a background operation. The controller 3100 is configured to provide an interface between the memory device 3200 and a host. The controller 3100 may be configured to drive firmware that controls the memory device 3200. For example, the controller 3100 may include components such as a Random Access Memory (RAM), a processing unit, a host interface, a memory interface, and an error corrector.

The controller 3100 communicates with an external device through the connector 3300. The controller 3100 communicates with the external device, for example, the host, according to a specific communication protocol. For example, the controller 3100 may be configured to communicate with the external device through at least one of various communication protocols such as Universal Serial Bus (USB), Multi-Media Card (MMC), embedded MMC (eMMC), Peripheral Component Interconnect (PCI), PCI express (PCI-E), Advanced Technology Attachment (ATA), Serial-ATA (SATA), Parallel-ATA (PATA), Small Computer System Interface (SCSI), Enhanced Small Disk Interface (ESDI), Integrated Drive Electronics (IDE), Firewire, Universal Flash Storage (UFS), Wi-Fi, Bluetooth, and NVMe protocols. For example, the connector 3300 may be configured according to at least one of these communication protocols.

The memory device 3200 includes a plurality of memory cells configured, for example, in the same manner as the memory device 100 shown in FIG. 1, FIG. 3A, FIG. 5A, and formed utilizing the method of manufacturing a memory device according to the method described with reference to FIG. 4A through FIG. 4Z or FIG. 6A through FIG. 6N.

The controller 3100 and the memory device 3200 are integrated into a single semiconductor device to constitute a memory card. For example, the controller 3100 and the memory device 3200 may be integrated into a single semiconductor device to constitute a memory card such as a personal computer (PC) card in the form of a Personal Computer Memory Card International Association (PCMCIA) card, a Compact Flash (CF) card, a Smart Media Card (SM and SMC), a memory stick, a Multi-Media Card (MMC, RS-MMC, MMCmicro, or eMMC), a Secure Digital (SD) card (SD, miniSD, microSD, or SDHC), and a Universal Flash Storage (UFS).

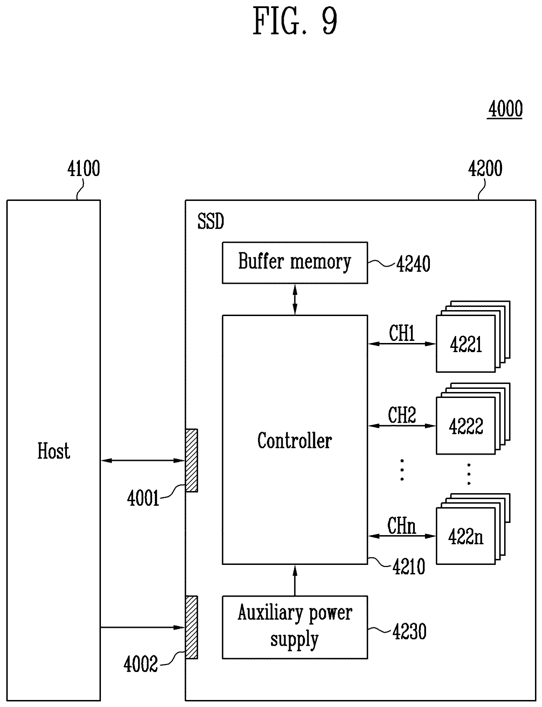

FIG. 9 is a diagram illustrating a solid state drive (SSD) system 4000 including a memory device according to an embodiment of the present disclosure.

Referring to FIG. 9, the SSD system 4000 includes a host 4100 and an SSD 4200. The SSD 4200 exchanges a signal with the host 4100 through a signal connector 4001 and receives power through a power connector 4002. The SSD 4200 includes a controller 4210, a plurality of memory devices 4221 to 422n, an auxiliary power supply 4230, and a buffer memory 4240.

The controller 4210 controls the plurality of memory devices 4221 to 422n in response to signals received from the host 4100. For example, the signals may be based on an interface between the host 4100 and the SSD 4200. For example, the signals may be configured or constructed according to at least one of a plurality of interfaces such as Universal Serial Bus (USB), Multi-Media Card (MMC), embedded MMC (eMMC), Peripheral Component Interconnect (PCI), PCI express (PCI-E), Advanced Technology Attachment (ATA), Serial-ATA (SATA), Parallel-ATA (PATA), Small Computer System Interface (SCSI), Enhanced Small Disk Interface (ESDI), Integrated Drive Electronics (IDE), Firewire, Universal Flash Storage (UFS), Wi-Fi, Bluetooth, and NVMe interfaces.

The plurality of memory devices 4221 to 422n each includes a plurality of memory cells configured to store data. Each of the plurality of memory devices 4221 to 422n is configured in the same manner as the memory device 100 shown in FIG. 1, FIG. 3A, FIG. 5A, and formed utilizing the method of manufacturing a memory device according to the method described with reference to FIG. 4A through FIG. 4Z or FIG. 6A through FIG. 6N. The plurality of memory devices 4221 to 422n communicates with the controller 4210 through channels CH1 to CHn.

The auxiliary power supply 4230 is coupled to the host 4100 through a power connector 4002. The auxiliary power supply 4230 receives and is charged with a power from the host 4100. When the supply of power from the host 4100 is not smooth, the auxiliary power supply 4230 provides power to the SSD 4200. For example, the auxiliary power supply 4230 may be located in or outside the SSD 4200. For example, the auxiliary power supply 4230 may be located on a main board and provide auxiliary power to the SSD 4200.

The buffer memory 4240 is a buffer memory for the SSD 4200. For example, the buffer memory 4240 stores data received from the host 4100 or data received from the plurality of memory devices 4221 to 422n, or may store metadata, for example, mapping tables, of the memory devices 4221 to 422n. The buffer memory 4240 may include volatile memories such as DRAM, SDRAM, DDR SDRAM, and LPDDR SDRAM, or non-volatile memories such as FRAM, ReRAM, STT-MRAM, and PRAM.

According to embodiments of the present disclosure, the support effectiveness of a support structure of a memory device may be enhanced, and the manufacturing process may be simplified by improving the manufacturing process and structure of the support structure.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to these descriptions. All changes within the meaning and range of equivalency of the claims are included within their scope.

## Claims

1. A memory device comprising:
a contact; and
a plurality of support structures disposed around the contact;
wherein each of the plurality of support structures is formed in a plurality of overlapping holes.

2. The memory device of claim 1, wherein each of the plurality of support structures includes an insulating layer disposed in the overlapping holes.

3. The memory device of claim 1, wherein each of the plurality of support structures is formed utilizing two overlapping holes; and
wherein the two overlapping holes extend in a direction away from the contact.

4. The memory device of claim 1, wherein each of the plurality of support structures is formed utilizing three overlapping holes, and
wherein centers of the three overlapping holes form vertices of a triangle.

5. The memory device of claim 1, wherein each of the plurality of support structures is formed utilizing four overlapping holes and at least two overlapping holes among the four overlapping holes include a common region; and
wherein centers of the four overlapping holes are arranged to form vertices of a quadrilateral.

6. The memory device of claim 1, wherein each of the plurality of support structures is formed utilizing four overlapping holes, at least two overlapping holes among the four overlapping holes include a common region; and
wherein the four overlapping holes are arranged to surround the contact.

7. The memory device of claim 1, further comprising a stack structure including a plurality of conductive layers and a plurality of interlayer insulating layers stacked alternately in a first direction,
wherein the contact extends from a first conductive layer among the plurality of conductive layers in the first direction, and
wherein the plurality of support structures extend through the stack structure in the first direction.

8. The memory device of claim 7, wherein the first conductive layer contacts a lower surface of the contact.

9. The memory device of claim 7, further comprising a spacer surrounding a side surface of the contact,
wherein the spacer separates the contact from conductive layers of the plurality of conductive layers other than the first conductive layer.

10. The memory device of claim 9, wherein the plurality of support structures contact an outer surface of the spacer and a lower surface of the contact.

11. The memory device of claim 1, wherein four or more support structures are disposed around the contact.

12. The memory device of claim 1, wherein three support structures are disposed around the contact, and further comprising a plurality of support pillars, each of the plurality of support pillars disposed between consecutive support structures of the plurality of support structures.

13. The memory device of claim 12, further comprising:
a stack structure including a plurality of conductive layers and a plurality of interlayer insulating layers stacked alternately in a first direction; and
a plurality of cell plugs extending through the stack structure in the first direction;
wherein the plurality of support pillars includes dummy material layers corresponding to material layers included in the cell plugs.

14. The memory device of claim 13, wherein each of the cell plugs includes a memory layer, a channel layer, and a gap-fill layer, and
wherein each of the support pillars includes a dummy memory layer corresponding to the memory layer, a dummy channel layer corresponding to the channel layer, and a dummy gap-fill layer corresponding to the gap-fill layer.

15. The memory device of claim 12, wherein each of the plurality of support pillars are spaced apart from the contact and the plurality of support structures.
